# EUROPEAN PATENT SPECIFICATION

(11) **EP 4 386 846 B1**
(45) Date of publication and mention of the grant of the patent: **09.12.2026**
(21) Application number: 22855706.2
(22) Date of filing: 16.03.2022
(51) Int. Cl.: H10F 39/00

(54) **IMAGING DEVICE, AND ELECTRONIC APPARATUS**
BILDGEBUNGSVORRICHTUNG UND ELEKTRONISCHE VORRICHTUNG
DISPOSITIF D'IMAGERIE ET APPAREIL ÉLECTRONIQUE

(30) Priority: 13.08.2021 JP 2021131982
(43) Date of publication of application: 19.06.2024
(73) Proprietor: Sony Semiconductor Solutions Corporation, Atsugi-shi, Kanagawa 243-0014 (JP)
(72) Inventor: NISHIDA, Keiji, Atsugi-shi, Kanagawa 243-0014 (JP); NAKAMURA, Yusuke, Atsugi-shi, Kanagawa 243-0014 (JP); SUGIMOTO, Masataka, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/012067
(87) International publication number: WO 2023/017640

(56) References cited:
- DE-T5- 112019 003 449
- JP-A- 2016 136 584
- JP-A- 2020 009 883
- JP-A- 2021 005 619
- JP-A- 2021 005 619
- US-A1- 2015 243 693
- US-A1- 2015 243 693
- US-A1- 2015 279 899
- US-A1- 2016 218 138

## Description

### Field

The present disclosure relates to an imaging apparatus and an electronic device.

### Background

Conventionally, in a complementary metal-oxide-semiconductor (CMOS) type solid-state image pickup element (CMOS image sensor), in order to increase the amount of charges that can be accumulated in a photodiode that performs photoelectric conversion of a pixel portion, a potential that can accumulate charges in a deep region may be formed. In such a case, by using a vertical gate electrode inserted into silicon instead of a normal transfer gate, modulation is performed to a deep region, and an electric field is applied to perform reading. In addition, a structure employing a plurality of vertical gate electrodes in order to increase the modulation force has also been proposed.

Patent Literature 2 discloses a CMOS image sensor. The CMOS image sensor can include a substrate having a first device isolation layer defining and dividing a first active region and a second active region, a photodiode disposed in the substrate and can be configured to vertically overlap the first device isolation layer, a transfer gate electrode can be disposed in the first active region and can be configured to vertically overlap the photodiode, and a floating diffusion region can be in the first active region. The transfer gate electrode can be buried in the substrate.

Patent Literature 3 discloses a imaging apparatus with a first semiconductor substrate includes a first substrate having a photoelectric conversion unit and a first transistor constituting a sensor pixel, and a second semiconductor substrate having a second transistor that constitutes a sensor pixel and has a channel region different from a crystal lattice constant of the first semiconductor substrate, and a second substrate laminated on the first substrate.

Patent Literature 4 discloses a light receiving element for indirect Time-of-Flight (ToF) distance measurement. A pixel includes a photodiode, first and second charge holding units (floating diffusion regions), and first and second transfer transistors, wherein the transfer transistors are vertical transistors having comb-shaped vertical gate electrode portions extending into the substrate. The vertical gate structure shortens charge transfer paths, improves charge transfer efficiency, reduces signal degradation caused by charge return to the photodiode, and enhances ToF distance measurement performance.

Patent Literature 5 discloses a solid-state image pickup device including a photoelectric conversion element, a floating diffusion region, and a transfer transistor having a plurality of trench gates extending from the semiconductor surface toward the photoelectric conversion element. A semiconductor channel region is provided between the trench gates and faces the floating diffusion. By applying a voltage between the trench gates, the device lowers the transfer barrier, improves charge-transfer efficiency from the photoelectric conversion element to the floating diffusion, and suppresses dark current generation.

### Citation List

### Patent Literature

Patent Literature 1: JP 2018-190797 A
Patent Literature 2: US 2015/243693 A1
Patent Literature 3: JP 2021 005619 A
Patent Literature 4: DE 11 2019 003449 T5
Patent Literature 5: US 2016/218138 A1

### Summary

### Technical Problem

Here, in the conventional element structure, it is necessary to make the width of the transfer gate electrode in the channel length direction larger than the diameter of the vertical gate electrode in order to suppress a decrease in transfer efficiency when the charge accumulated in the photodiode is extracted. However, when the width of the transfer gate electrode is increased, an electron avalanche may occur due to the strong electric field formed by the approach of the transfer gate electrode and the floating diffusion region, and accordingly, there is a problem that image quality degradation such as a white spot caused by saturation of the amplitude of the pixel signal occurs.

Therefore, the present disclosure proposes an imaging apparatus and an electronic device capable of suppressing deterioration in image quality while suppressing deterioration in transfer efficiency.

### Solution to Problem

According to a first aspect the present disclosure provides an imaging apparatus in accordance with independent claim 1. According to a second aspect the present disclosure provides an electronic device in accordance with independent claim 15. Further aspects are set forth in the dependent claims, the drawings, and the following description.

In order to solve the problem described above, an imaging apparatus according to an embodiment of the present disclosure includes a plurality of pixels arrayed in a two-dimensional lattice pattern, in which each of the pixels includes a photoelectric conversion unit provided on a first surface side of a semiconductor substrate to perform photoelectric conversion of incident light, a vertical gate electrode provided on the semiconductor substrate so as to be close to the photoelectric conversion unit from a second surface side opposite to the first surface, a gate insulating film provided between the vertical gate electrode and the semiconductor substrate, a transfer gate electrode connected to the vertical gate electrode on the second surface of the semiconductor substrate, and a first diffusion region provided on a second surface side of the semiconductor substrate, and the vertical gate electrode has a structure in which a bottom portion on the photoelectric conversion unit side is enlarged in diameter more than an upper portion on the transfer gate electrode side.

### Brief Description of Drawings

FIG. 1 is a block diagram depicting a schematic configuration example of an imaging apparatus applied to each embodiment of the present disclosure.
FIG. 2 is a diagram for explaining an example of a seat term structure of an imaging apparatus applied to each embodiment of the present disclosure.
FIG. 3 is a circuit diagram depicting an example of a pixel and a readout circuit depicted in FIG. 2.
FIG. 4 is a block diagram depicting a configuration example of an imaging apparatus mounted on an electronic device applied to each embodiment of the present disclosure.
FIG. 5 is a top view depicting a schematic configuration example of a pixel according to the first embodiment.
FIG. 6 is a vertical cross-sectional view depicting a structural example of an A-A' cross section in FIG. 5.
FIG. 7 is a vertical cross-sectional view depicting a structural example of a B-B' cross section in FIG. 5.
FIG. 8 is a vertical cross-sectional view depicting a structural example of a C-C' cross section in FIG. 5.
FIG. 9 is a process cross-sectional view depicting an example of a manufacturing process of the pixel according to the first embodiment (part 1).
FIG. 10 is a process cross-sectional view depicting an example of a manufacturing process of the pixel according to the first embodiment (part 2).
FIG. 11 is a process cross-sectional view depicting an example of a manufacturing process of the pixel according to the first embodiment (part 3).
FIG. 12 is a process cross-sectional view depicting an example of a manufacturing process of the pixel according to the first embodiment (part 4).
FIG. 13 is a process cross-sectional view depicting an example of a manufacturing process of the pixel according to the first embodiment (part 5).
FIG. 14 is a process cross-sectional view depicting an example of a manufacturing process of the pixel according to the first embodiment (part 6).
FIG. 15 is a process cross-sectional view depicting an example of a manufacturing process of the pixel according to the first embodiment (part 7).
FIG. 16 is a process cross-sectional view depicting an example of a manufacturing process of the pixel according to the first embodiment (part 8).
FIG. 17 is a process cross-sectional view depicting an example of a manufacturing process of the pixel according to the first embodiment (part 9).
FIG. 18 is a top view depicting a schematic configuration example of a pixel according to a second embodiment.
FIG. 19 is a vertical cross-sectional view depicting a structural example of an A-A' cross section in FIG. 18.
FIG. 20 is a vertical cross-sectional view depicting a schematic configuration example of a pixel according to a third embodiment.
FIG. 21 is a vertical cross-sectional view depicting a schematic configuration example of a pixel according to a fourth embodiment.
FIG. 22 is a vertical cross-sectional view depicting a schematic configuration example of a pixel according to a fifth embodiment.
FIG. 23 is a vertical cross-sectional view depicting a schematic configuration example of a pixel according to a sixth embodiment.
FIG. 24 is a top view depicting a schematic configuration example of a pixel according to a seventh embodiment.
FIG. 25 is a top view depicting a schematic configuration example of a pixel according to an eighth embodiment.
FIG. 26 is a top view depicting a schematic configuration example of a pixel according to a ninth embodiment.
FIG. 27 is a partial cross-sectional view depicting a structure example of a pixel according to a tenth embodiment.
FIG. 28 is a partial cross-sectional view depicting a structure example of a pixel according to an eleventh embodiment.
FIG. 29 is a block diagram depicting an example of schematic configuration of a vehicle control system.
FIG. 30 is a diagram of assistance in explaining an example of installation positions of an outside-vehicle information detecting section and an imaging section.
FIG. 31 is a view depicting an example of a schematic configuration of an endoscopic surgery system.
FIG. 32 is a block diagram depicting an example of a functional configuration of a camera head and a camera control unit (CCU).

### Description of Embodiments

Hereinafter, an embodiment of the present disclosure will be described in detail with reference to the drawings. In the following embodiments, the same parts are denoted by the same reference numerals, and redundant description will be omitted.

Further, the present disclosure will be described according to the following order of items.
1. Common Configuration
1.1 Schematic Configuration Example of Imaging Apparatus
1.2 Stacked Structure Example of Imaging Apparatus
1.3 Schematic Configuration Example of Electronic Device
2. First Embodiment
2.1 Pixel Configuration Example
2.2 Production Process Example
2.3 Summary
3. Second Embodiment
4. Third Embodiment
5. Fourth Embodiment
6. Fifth Embodiment
7. Sixth Embodiment
8. Seventh Embodiment
9. Eighth Embodiment
10. Ninth Embodiment
11. Tenth Embodiment
12. Eleventh Embodiment
13. Application Example to Mobile Body
14. Application Example to Endoscopic Surgery System

### 1. Common Configuration

First, configurations of an imaging apparatus and an electronic device common to the following embodiments will be described in detail with reference to the drawings.

### 1.1 Schematic Configuration Example of Imaging Apparatus

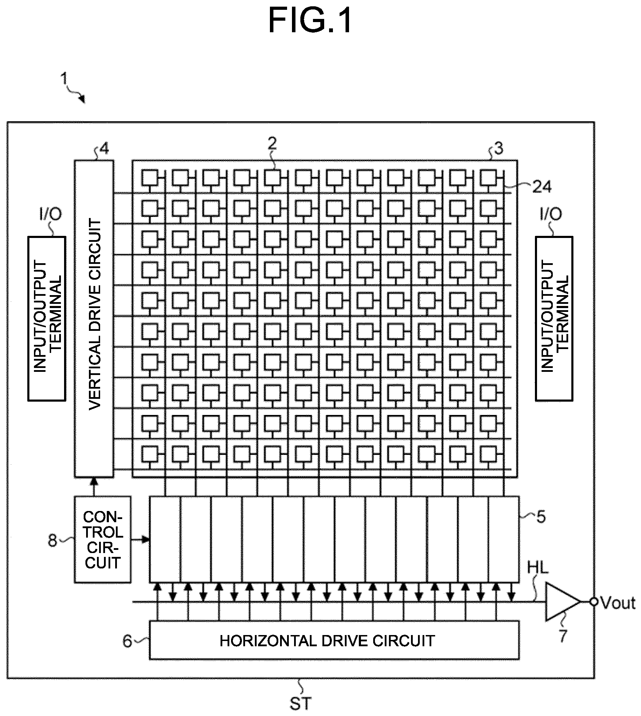

FIG. 1 is a block diagram depicting a schematic configuration example of an imaging apparatus applied to each embodiment of the present disclosure. As depicted in FIG. 1, the imaging apparatus 1 includes a pixel array unit (so-called imaging region) 3 in which pixels 2 including a plurality of photoelectric conversion elements are regularly and two-dimensionally arrayed on a semiconductor substrate ST (for example, a silicon substrate), and a peripheral circuit unit. The pixels 2 includes, for example, a photodiode serving as a photoelectric conversion element and a plurality of pixel transistors (so-called MOS transistors). The plurality of pixel transistors includes, for example, three transistors: a transfer transistor, a reset transistor, and an amplification transistor. In addition, a selection transistor may be added to configure the pixel transistor with four transistors. Since an equivalent circuit of the unit pixel is similar to a normal case, a detailed description thereof will be omitted. The pixels 2 may have a shared pixel structure. This pixel sharing structure includes a plurality of photodiodes, a plurality of transfer transistors, one shared floating diffusion, and each one of other shared pixel transistors.

The peripheral circuit unit includes a vertical drive circuit 4, column signal processing circuits 5, a horizontal drive circuit 6, an output circuit 7, and a control circuit 8, and the like.

The control circuit 8 receives an input clock and data instructing an operation mode and the like, and outputs data such as internal information of the imaging apparatus. That is, in the control circuit 8, a clock signal or a control signal serving as a reference of operations of the vertical drive circuit 4, the column signal processing circuit 5, the horizontal drive circuit 6, and the like is generated on the basis of the vertical synchronization signal, the horizontal synchronization signal, and the master clock. Then, these signals are input to the vertical drive circuit 4, the column signal processing circuits 5, the horizontal drive circuit 6, and the like.

The vertical drive circuit 4 includes, for example, a shift register, selects a pixel drive line, supplies a pulse for driving the pixels to the selected pixel drive line, and drives the pixels in units of rows. That is, the vertical drive circuit 4 sequentially selects and scans each of the pixels 2 in the pixel array unit 3 in the vertical direction in units of rows, and supplies a pixel signal based on a signal charge generated according to the amount of received light in, for example, a photodiode serving as a photoelectric conversion element of each of the pixels 2 to the column signal processing circuits 5 through the vertical signal line 24.

The column signal processing circuit 5 is arranged, for example, for each column of the pixels 2, and performs signal processing such as noise removal on the signals output from the pixels 2 of one row for each pixel column. That is, the column signal processing circuits 5 performs signal processing such as correlated double sampling (CDS) for removing fixed pattern noise unique to the pixels 2, signal amplification, and AD conversion. In the output stage of the column signal processing circuits 5, a horizontal selection switch (not illustrated) is connected and provided between the column signal processing circuit and a horizontal signal line HL.

The horizontal drive circuit 6 includes, for example, a shift register, sequentially selects each of the column signal processing circuits 5 by sequentially outputting horizontal scanning pulses, and causes each of the column signal processing circuits 5 to output a pixel signal to the horizontal signal line HL.

The output circuit 7 performs signal processing on the signals sequentially supplied from each of the column signal processing circuits 5 through the horizontal signal line HL, and outputs the processed signals. For example, only buffering may be performed, or black level adjustment, column variation correction, various digital signal processing, and the like may be performed. An input/output terminal I/O exchanges signals externally.

### 1.2 Stacked Structure Example of Imaging Apparatus

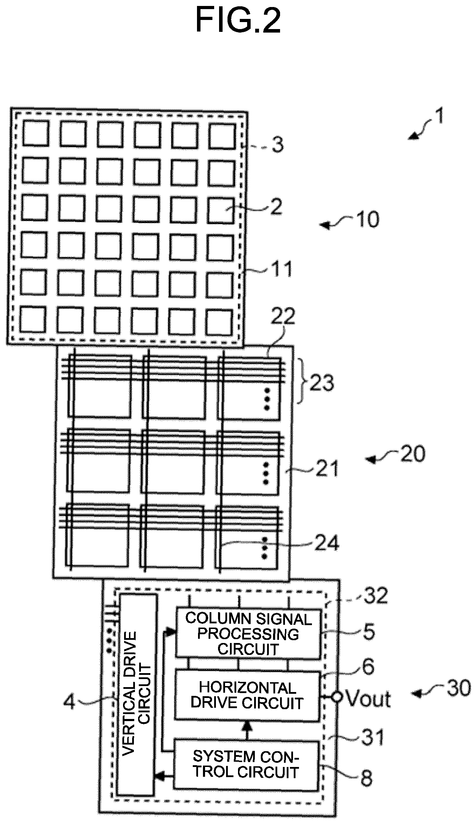

Next, a stacked structure example of the imaging apparatus 1 applied to each embodiment of the present disclosure will be described. FIG. 2 is a diagram for explaining an example of a seat term structure of an imaging apparatus applied to each embodiment of the present disclosure. As depicted in FIG. 2, the imaging apparatus 1 can have a three-dimensional structure formed by bonding three substrates (first substrate 10, second substrate 20, and third substrate 30). The first substrate 10, the second substrate 20, and the third substrate 30 are stacked in this order.

The first substrate 10 includes a plurality of pixels 2 that performs photoelectric conversion on a semiconductor substrate 11. The plurality of pixels 2 is provided in a matrix in the pixel array unit 3 of the first substrate 10. The second substrate 20 includes, on a semiconductor substrate 21, one readout circuit 22 for each of the four pixels 2 that outputs a pixel signal based on the charge output from the pixel 2. The second substrate 20 includes a plurality of pixel drive lines 23 extending in the row direction and a plurality of vertical signal lines 24 extending in the column direction. The third substrate 30 includes a logic circuit 32 that processes a pixel signal on a semiconductor substrate 31. The logic circuit 32 includes, for example, a vertical drive circuit 4, a column signal processing circuit 5, a horizontal drive circuit 6, and a control circuit 8. The logic circuit 32 (specifically, the horizontal drive circuit 6) outputs the output voltage Vout for each of the pixels 2 to the outside. In the logic circuit 32, for example, a low resistance region made of silicide formed using a self-aligned silicide process such as CoSi₂ or NiSi may be formed on the surface of the impurity diffusion region in contact with the source electrode and the drain electrode.

For example, the vertical drive circuit 4 sequentially selects the plurality of pixels 2 row by row. For example, the column signal processing circuit 5 performs CDS processing on the pixel signal output from each of the pixels 2 of the row selected by the vertical drive circuit 4. The column signal processing circuit 5 extracts a signal level of a pixel signal by performing CDS processing, for example, and holds pixel data corresponding to the amount of received light of each of the pixels 2. For example, the horizontal drive circuit 6 sequentially outputs the pixel data held in the column signal processing circuit 5 to the outside. The control circuit 8 controls driving of each block (vertical drive circuit 4, column signal processing circuit 5, and horizontal drive circuit 6) in the logic circuit 32, for example.

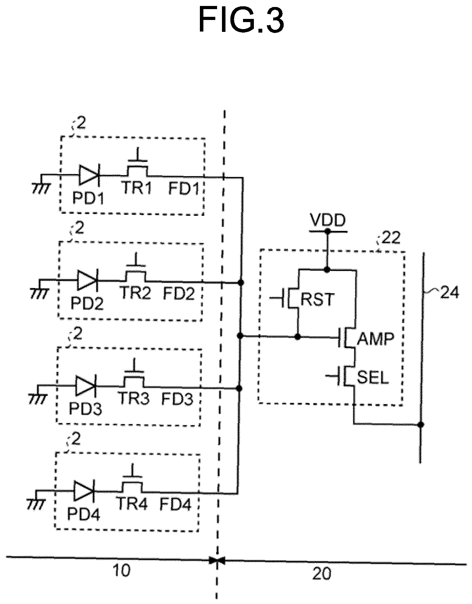

FIG. 3 illustrates an example of the pixels 2 and the readout circuit 22. Hereinafter, as illustrated in FIG. 3, a case where four pixels 2 share one readout circuit 22 will be described. Here, "share" means that the outputs of the four pixels 2 are input to the common readout circuit 22.

Each of the pixels 2 has a common component. In FIG. 3, identification numbers (1, 2, 3, and 4) are added to the ends of the signs of the constituent elements of each of the pixels 2 in order to distinguish the constituent elements of the pixels 2 from each other. Hereinafter, if it is necessary to distinguish the components of the pixels 2 from each other, an identification number is assigned to the end of the reference sign of the component of each of the pixels 2, but if it is not necessary to distinguish the components of the pixels 2 from each other, the identification number at the end of the reference sign of the component of each of the pixels 2 is omitted.

Each of the pixels 2 includes, for example, a photodiode PD, a transfer transistor TR electrically connected to the photodiode PD, and a floating diffusion region FD that temporarily holds the charge output from the photodiode PD via the transfer transistor TR. The photodiode PD corresponds to a specific example of a "photoelectric conversion unit" of the present disclosure. The photodiode PD performs photoelectric conversion to generate a charge corresponding to the amount of received light. A cathode of the photodiode PD is electrically connected to a source of the transfer transistor TR, and an anode of the photodiode PD is electrically connected to a reference potential line (for example, ground). The drain of the transfer transistor TR is electrically connected to the floating diffusion region FD, and the gate of the transfer transistor TR is electrically connected to the pixel drive line 23. The transfer transistor TR is, for example, a CMOS transistor.

The floating diffusion regions FD of the pixels 2 sharing one readout circuit 22 are electrically connected to each other and electrically connected to the input end of the common readout circuit 22. The readout circuit 22 includes, for example, a reset transistor RST, a selection transistor SEL, and an amplification transistor AMP. Note that the selection transistor SEL may be omitted as necessary. The source of the reset transistor RST (the input end of the readout circuit 22) is electrically connected to the floating diffusion region FD, and the drain of the reset transistor RST is electrically connected to the power supply line VDD and the drain of the amplification transistor AMP. A gate of the reset transistor RST is electrically connected to the pixel drive line 23 (see FIG. 2). The source of the amplification transistor AMP is electrically connected to the drain of the selection transistor SEL, and the gate of the amplification transistor AMP is electrically connected to the source of the reset transistor RST. A source of the selection transistor SEL (an output end of the readout circuit 22) is electrically connected to the vertical signal line 24, and a gate of the selection transistor SEL is electrically connected to the pixel drive line 23 (see FIG. 2).

### 1.3 Schematic Configuration Example of Electronic Device

In addition, the imaging apparatus 1 as described above can be applied to various electronic devices, such as an imaging system such as a digital still camera or a digital video camera, a mobile phone having an imaging function, or another device having an imaging function, for example.

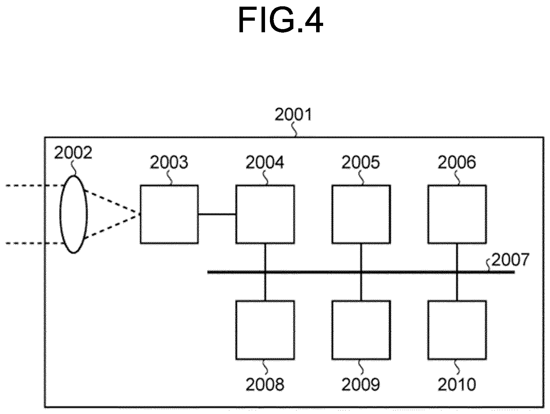

FIG. 4 is a block diagram depicting a configuration example of an imaging apparatus mounted on an electronic device.

As depicted in FIG. 4, an electronic device 2001 includes an optical system 2002, an imaging apparatus 2003, and a digital signal processor (DSP) 2004. The DSP 2004, a display apparatus 2005, an operation system 2006, a memory 2008, a recording apparatus 2009, and a power supply system 2010 are connected via a bus 2007, and can capture a still image and a moving image.

The optical system 2002 includes one or a plurality of lenses, guides image light from a subject (incident light) to the imaging apparatus 2003, and forms an image on a light receiving surface (sensor unit) of the imaging apparatus 2003.

As the imaging apparatus 2003, the imaging apparatus 1 of any of the above-described configuration examples is applied. Electrons are accumulated in the imaging apparatus 2003 for a certain period according to an image formed on the light receiving surface via the optical system 2002. Then, a signal corresponding to the electrons accumulated in the imaging apparatus 2003 is supplied to the DSP 2004.

The DSP 2004 performs various types of signal processing on the signal from the imaging apparatus 2003 to acquire an image, and temporarily stores data of the image in the memory 2008. The image data stored in the memory 2008 is recorded in the recording apparatus 2009 or supplied to the display apparatus 2005 to display an image. Furthermore, the operation system 2006 receives various operations by the user and supplies an operation signal to each block of the electronic device 2001, and the power supply system 2010 supplies power necessary for driving each block of the electronic device 2001.

In the electronic device 2001 configured as described above, by applying the imaging apparatus 1 as described above as the imaging apparatus 2003, the number of layers of a metal layer 58 can be more effectively reduced, and cost reduction can be achieved.

### 2. First Embodiment

First, an imaging apparatus and an electronic device according to the first embodiment will be described in detail with reference to the drawings. Note that, in the present embodiment, a pixel 100 may have a configuration corresponding to the pixels 2 provided on the first substrate 10 in the above-described common configuration example.

### 2.1 Pixel Configuration Example

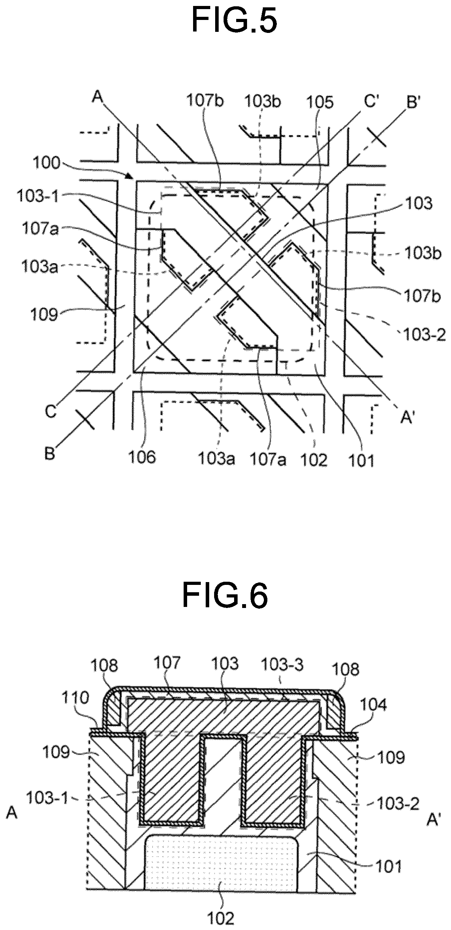

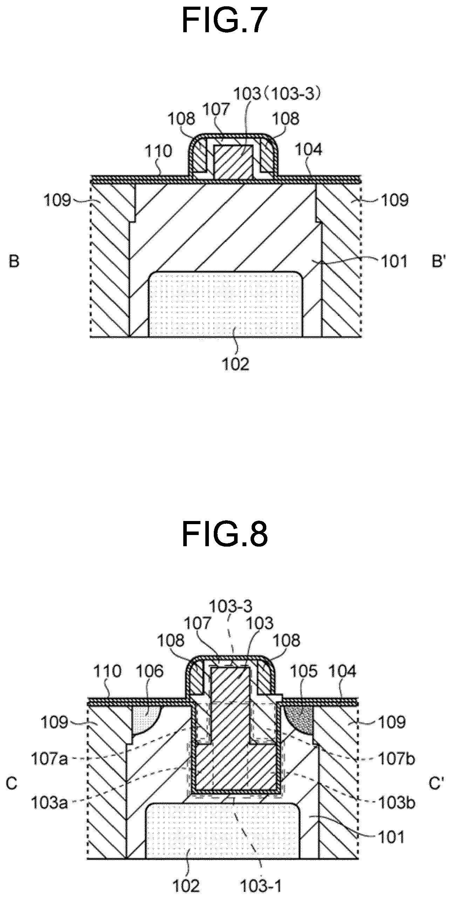

FIG. 5 is a top view depicting a schematic configuration example of a pixel according to the present embodiment. FIG. 6 is a vertical cross-sectional view depicting a structural example of an A-A' cross section in FIG. 5. FIG. 7 is a vertical cross-sectional view depicting a structural example of a B-B' cross section in FIG. 5. FIG. 8 is a vertical cross-sectional view depicting a structural example of a C-C' cross section in FIG. 5.

As depicted in FIGS. 5 to 8, in the present embodiment, one pixel 100 is provided in each pixel region divided in a two-dimensional lattice pattern by the pixel isolation section 109 partitioning a semiconductor substrate 101.

The pixel 100 includes a photoelectric conversion unit 102 provided to be biased to, for example, the back surface side (lower surface side in the drawing) of the semiconductor substrate 101, a transfer gate 103 for extracting charges accumulated in the photoelectric conversion unit 102 to the front surface side (upper surface side in the drawing) of the semiconductor substrate 101, a gate insulating film 104 provided between the transfer gate 103 and the semiconductor substrate 101, a floating diffusion region 105 provided at one of the four corners of the pixel region in the upper layer of the semiconductor substrate 101, a ground contact 106 provided at a corner located diagonally to the corner where the floating diffusion region 105 is provided among the four corners of the pixel region in the upper layer of the semiconductor substrate 101, and an insulating film 107 provided at least between the transfer gate 103 and the floating diffusion region 105 and/or the ground contact 106.

In the above configuration, the transfer gate 103 includes a plurality of vertical gate electrodes 103-1 and 103-2 protruding in the substrate thickness direction from the front surface side of the semiconductor substrate 101 such that the tip (corresponding to the bottom surface) approaches the photoelectric conversion unit 102, and a transfer gate electrode 103-3 connecting the plurality of vertical gate electrodes 103-1 and 103-2 on the front surface of the semiconductor substrate 101. Note that, in the present example, a case where the number of vertical gate electrodes is two and the transfer gate 103 has a π-shaped shape as a whole is exemplified, but the present invention is not limited thereto, and the number of vertical gate electrodes may be one or three or more. Furthermore, in the present example, a case where the pixel structure of the pixel 100 including the transfer gate 103 has a line-symmetric structure with a line connecting the floating diffusion region 105 and the ground contact 106 as a center line will be exemplified, but the present invention is not limited thereto, and the pixel structure may be asymmetric.

Each of the vertical gate electrodes 103-1 and 103-2 has a structure in which the upper portion side (transfer gate electrode 103-3 side) has a diameter substantially equal to the width of the transfer gate electrode 103-3, and the bottom surface side (photoelectric conversion unit 102 side) is enlarged in diameter more than the upper portion side. That is, in the present example, when the semiconductor substrate 101 is viewed from above, the enlarged diameter portions 103a and 103b on the bottom surface side of the vertical gate electrodes 103-1 and 103-2 protrude from the transfer gate electrode 103-3 on the semiconductor substrate 101.

The enlarged diameter portions 103a and 103b is provided at positions deeper than the depth position of the floating diffusion region 105.

As described above, by adopting a structure in which the bottom surface side of each of the vertical gate electrodes 103-1 and 103-2 is larger in diameter than the upper side, it is possible to increase the area of the surface (bottom surface) of the transfer gate 103 facing the photoelectric conversion unit 102 while securing the distance from the transfer gate electrode 103-3 to the floating diffusion region 105 and/or the ground contact 106, and thus it is possible to suppress deterioration in transfer efficiency while suppressing deterioration in image quality due to formation of the strong electric field.

As depicted in FIG. 8, the widths of the enlarged diameter portions 103a and 103b in the channel length direction in the vertical gate electrodes 103-1 and 103-2 may be the same or different. In a case where the widths are different, for example, the width of the enlarged diameter portion 103b on the floating diffusion region 105 side may be larger than the width of the enlarged diameter portion 103a on the ground contact 106 side. As a result, it is possible to further suppress formation of a strong electric field between the transfer gate 103 and the floating diffusion region 105. Note that the channel length direction may be a direction connecting the floating diffusion region 105 and the transfer gate 103 (for example, the ground contact 106 on the extended line).

Furthermore, in the present example, the insulating film 107 is provided on an upper portion of each of the vertical gate electrodes 103-1 and 103-2. In the following description, the portions of the insulating film 107 disposed on the side surfaces of the vertical gate electrodes 103-1 and 103-2 are also referred to as embedded sidewalls 107a and 107b, respectively.

As described above, since the dielectric constant between the transfer gate 103 and the floating diffusion region 105 and/or the ground contact 106 can be lowered, the intensity of the electric field formed between the transfer gate 103 and the floating diffusion region 105 and/or the ground contact 106 can be further reduced.

The widths of the embedded sidewalls 107a and 107b in the channel length direction may be adjusted according to the widths of the enlarged diameter portions 103a and 103b immediately below.

Furthermore, in the present example, the insulating film 107 may be provided so as to cover the side surface and the upper surface of the transfer gate electrode 103-3 from the side surface of each of the vertical gate electrodes 103-1 and 103-2. A sidewall 108 made of an insulating film may be provided on a side surface of the mesa structure formed by the transfer gate electrode 103-3 covered with the insulating film 107. Furthermore, the surface of the semiconductor substrate 101 on which the transfer gate electrode 10303 and the like are formed may be covered with passivation 110 which is an insulating film.

### 2.2 Production Process Example

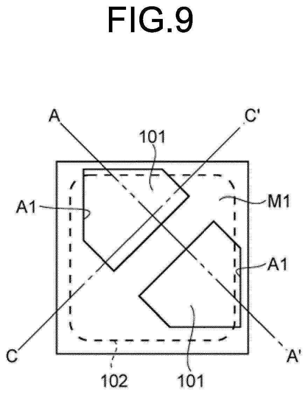

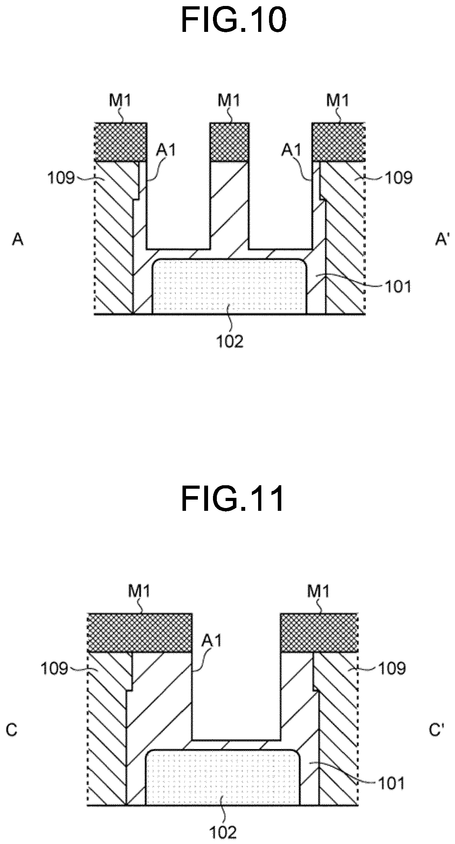

Next, an example of a manufacturing process of the pixel 100 according to the present embodiment will be described in detail with reference to the drawings. FIGS. 9 to 17 are process cross-sectional views depicting an example of a manufacturing process of the pixel according to the present embodiment. Note that FIG. 9 is a plan view of the semiconductor substrate 101 in which the pixel 100 is built as viewed from above, FIGS. 10, 12, 14, and 16 depict process cross-sectional views corresponding to the A-A' cross section in FIGS. 5 and 9, and FIGS. 11, 13, 15, and 17 depict process cross-sectional views corresponding to the C-C' cross section in FIGS. 5 and 9.

In the present manufacturing process example, first, as depicted in FIGS. 9 to 11, an N-type dopant is ion-implanted with predetermined implantation energy from the upper surface side into a semiconductor substrate 101 such as a silicon substrate, and the dopant thus implanted is thermally diffused to form the photoelectric conversion unit 102, which is a negative N-type diffusion region, in a region biased to the back surface side of the semiconductor substrate 101. For the semiconductor substrate 101, for example, a negative P-type semiconductor substrate may be used, or a P-type dopant may be thinly diffused. In the present description, the negative N-type refers to an N type having a small amount of free electrons, and the positive N type refers to an N type having a large amount of free electrons. Similarly, the negative P-type refers to a P type having a small amount of holes, and the positive P-type refers to a P type having a large amount of holes.

Subsequently, a trench reaching from the upper surface side to the back surface side is formed in a region where the pixel isolation section 109 for partitioning the semiconductor substrate 101 into individual pixel regions is formed, and the inside of the trench thus formed is filled with an insulator such as silicon oxide (SiO₂) or silicon nitride (SiN), thereby forming the pixel isolation section 109 that partitions the semiconductor substrate 101 into individual pixel regions.

Note that, in the present example, a so-called front full trench isolation (FFTI) type pixel isolation section reaching from the upper surface to the back surface of the semiconductor substrate 101 is exemplified as the pixel isolation section 109, but the pixel isolation section is not limited thereto, and a full trench isolation (FTI) type penetrating the semiconductor substrate 101 from the back surface side, or a deep trench isolation (DTI) type or reverse deep trench isolation (RDTI) type pixel isolation section formed from the front surface or the back surface to the middle of the semiconductor substrate 101 may be adopted.

Furthermore, in a case where the pixel isolation section 109 has a light confinement effect, a reflective material such as tungsten (W) may be embedded in a trench formed in the semiconductor substrate 101. At that time, when a conductive reflective material is embedded, an insulating film may be provided between the semiconductor substrate 101 and the trench.

Furthermore, in the present example, the pixel isolation section 109 is not limited to the pixel isolation structure having the trench structure, and may have, for example, a pixel isolation structure by a diffusion region. In that case, the pixel isolation section 109 may be, for example, a diffusion region in which a dopant having a polarity opposite to the polarity of the channel is implanted to a predetermined depth as a channel stopper.

Furthermore, not only the transfer gate 103 (transfer transistor TR) to be described later but also other transistors constituting the readout circuit 22 may be formed on the semiconductor substrate 101. That is, the imaging apparatus 1 according to the present embodiment is not limited to the three-layer stacked structure described above with reference to FIG. 2, and may have a single-layer structure or a stacked structure of two layers or four or more layers.

Subsequently, an insulating film such as a silicon oxide film (SiO₂) is formed on the upper surface of the semiconductor substrate 101, and the insulating film is patterned by photolithography and etching to form a hard mask M1 for forming a trench A1 in which the transfer gate 103 is formed. The opening shape of the hard mask may be, for example, the same shape as the contour shape when the transfer gate 103 including the vertical gate electrodes 103-1 and 103-2 and the transfer gate electrode 103-3 is viewed from the substrate thickness direction.

Then, the semiconductor substrate 101 is etched from the opening of the hard mask M1 formed as described above, thereby forming the trench A1 for forming the transfer gate 103. For etching of the semiconductor substrate 101, for example, anisotropic dry etching such as reactive ion etching (RIE) can be used. However, the present invention is not limited thereto, and the trench A1 may be formed by various methods.

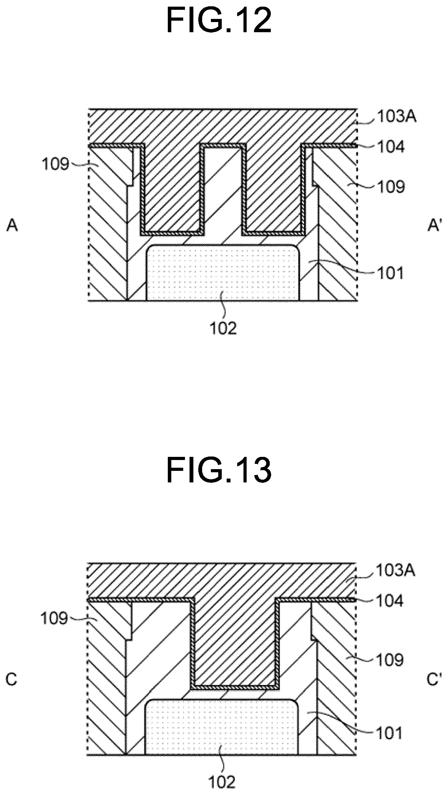

Thereafter, after the hard mask M1 is removed, as depicted in FIGS. 12 and 13, the gate insulating film 104 is formed on the upper surface of the semiconductor substrate 101 and the surface of the semiconductor substrate 101 in the trench A1. Annealing under an oxygen-rich condition can be used to form the gate insulating film 104. However, the present invention is not limited thereto, and the gate insulating film may be formed by using a sputtering method, a chemical vapor deposition (CVD) method, or the like. In addition, the insulating film formed on the upper surface of the semiconductor substrate 101 other than the inside of the trench A1 may be removed by chemical mechanical polishing (CMP), wet etching, or the like.

Subsequently, a conductor layer 103A to be processed into the transfer gate 103 is formed on the upper surface of the semiconductor substrate 101 on which the gate insulating film 104 is formed and in the trench A1. As a material of the conductor layer 103A, polysilicon, amorphous silicon, or the like having conductivity by containing impurities may be used. However, the present invention is not limited thereto, and other conductive materials such as metals and alloys may be used. In addition, various film forming techniques such as a sputtering method and a CVD method may be used for forming the conductor layer 103A. Furthermore, the surface of the conductor layer 103A formed on the semiconductor substrate 101 may be planarized by, for example, CMP or the like.

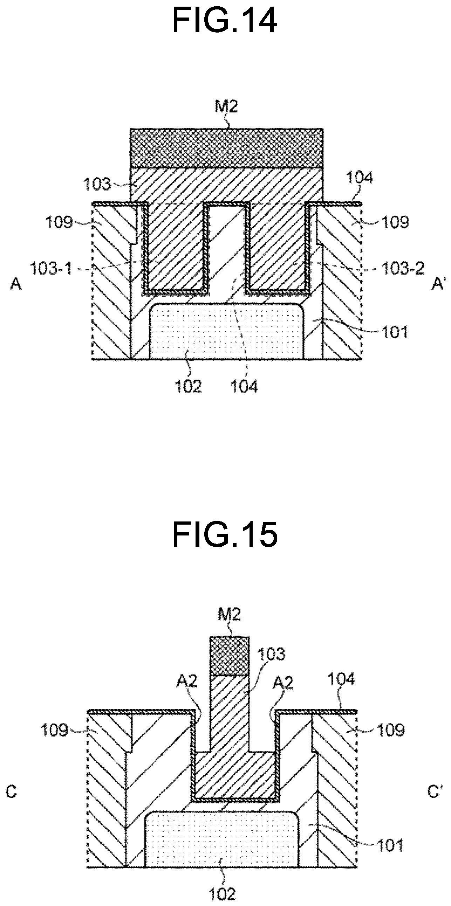

Next, as depicted in FIGS. 14 and 15, a hard mask M2 is formed on the conductor layer 103A by executing a film forming process by a sputtering method, a CVD method, or the like, and a patterning process by photolithography and etching, for example. The opening shape of the hard mask M2 may be, for example, the same shape as the contour shape when the transfer gate electrode 103-3 in the transfer gate 103 is viewed from the substrate thickness direction. Note that, as the material of the hard mask M2, an insulating material capable of securing an etching selectivity with respect to the gate insulating film 104 or the semiconductor substrate 101, such as a silicon nitride film (SiN), for example, may be used.

Subsequently, by etching the conductor layer 103A from the opening of the hard mask M2, while the conductor layer 103A on the semiconductor substrate 101 is processed into the transfer gate electrode 103-3, the conductor layer 103A in the trench A1 is processed into the vertical gate electrodes 103-1 and 103-2 whose upper side is reduced in diameter. For example, by performing over-etching so that the conductor layer 103A in the trench A1 is removed to a certain depth, it is possible to remove a part of the conductor layer 103A in the trench A1 and form the vertical gate electrodes 103-1 and 103-2 including the enlarged diameter portions 103a and 103b at the lower portions. For patterning the conductor layer 103A, for example, anisotropic dry etching of RIE may be used.

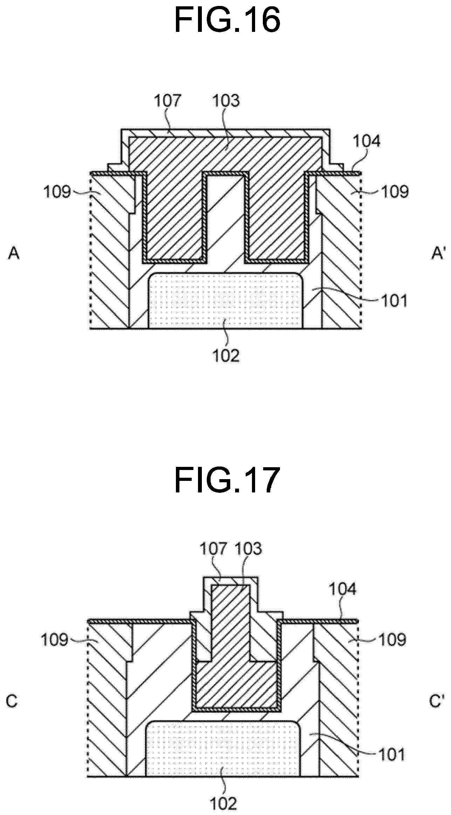

Next, as depicted in FIGS. 16 and 17, an insulating film is formed on the semiconductor substrate 101 on which the transfer gate 103 is formed so as to fill the gap in the trench A1, and patterning is performed by photolithography and etching to form the insulating film 107 having the embedded sidewalls 107a and 107b on the side surfaces of the vertical gate electrodes 103-1 and 103-2. As a material of the insulating film 107, for example, an insulating material capable of securing an etching selectivity with respect to the gate insulating film 104 may be used. For example, in a case where a silicon oxide film (SiO₂) is used for the gate insulating film 104, a silicon nitride film (SiN) or the like may be used for the insulating film 107.

Next, a sidewall 108 made of an insulating film such as silicon nitride (SiN) is formed on the side surface of the transfer gate electrode 103-3 covered with the insulating film 107. Subsequently, a floating diffusion region 105 that is a positive N-type diffusion region is formed at one of four corners of the pixel region in the upper layer portion of the semiconductor substrate 101 by, for example, an ion implantation method, and a ground contact 106 that is a positive P-type diffusion region is formed at a corner located diagonally to the corner by, for example, an ion implantation method. The ion-implanted dopant may be stabilized by annealing the upper surface of the semiconductor substrate 101. Thereafter, passivation 110 made of an insulating film is formed on the upper surface of the semiconductor substrate 101 on which the transfer gate 103 is formed, whereby the pixel 100 having the structure depicted in FIGS. 5 to 8 is formed.

### 2.3 Summary

As described above, according to the present embodiment, the photoelectric conversion unit 102 side of each of the vertical gate electrodes 103-1 and 103-2 is enlarged in diameter so as to protrude from the transfer gate electrode 103-3 (enlarged diameter portions 103a and 103b). As a result, it is possible to increase the area of the surface of the transfer gate 103 facing the photoelectric conversion unit 102 while securing the distance from the transfer gate electrode 103-3 to the floating diffusion region 105 and/or the ground contact 106, and thus it is possible to suppress deterioration in transfer efficiency while suppressing deterioration in image quality due to formation of the strong electric field.

In addition, by providing the enlarged diameter portions 103a and 103b at positions deeper than the depth of the floating diffusion region 105 and/or the ground contact 106 in the substrate thickness direction, it is possible to secure the distance from the vertical gate electrodes 103-1 and 103-2 to the floating diffusion region 105 and/or the ground contact 106, so that it is possible to suppress formation of a strong electric field between the vertical gate electrodes 103-1 and 103-2 and the floating diffusion region 105 and/or the ground contact 106.

Furthermore, by providing the insulating film 107 on the upper portion (portion not enlarged) of each of the vertical gate electrodes 103-1 and 103-2, since the dielectric constant between the transfer gate 103 and the floating diffusion region 105 and/or the ground contact 106 can be lowered, the intensity of the electric field formed between the transfer gate 103 and the floating diffusion region 105 and/or the ground contact 106 can be further reduced.

### 3. Second Embodiment

Next, an imaging apparatus and an electronic device according to the second embodiment will be described in detail with reference to the drawings. Note that, in the present embodiment, a pixel 200 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

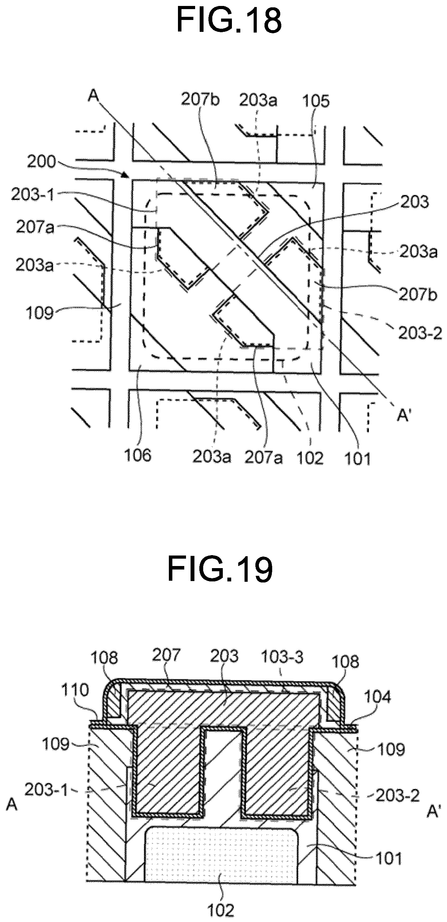

FIG. 18 is a top view depicting a schematic configuration example of a pixel according to the present embodiment. FIG. 19 is a vertical cross-sectional view depicting a structural example of an A-A' cross section in FIG. 18.

As depicted in FIGS. 18 and 19, the pixel 200 according to the present embodiment has a structure in which the transfer gate 103 and the insulating film 107 are replaced with a transfer gate 203 and an insulating film 207 in the same configuration as the pixel 100 described with reference to FIGS. 5 to 8 in the first embodiment.

The transfer gate 203 includes a transfer gate electrode 103-3 similar to that of the first embodiment and a plurality of vertical gate electrodes 203-1 and 203-2.

The vertical gate electrodes 203-1 and 203-2 have the same structure as the vertical gate electrodes 103-1 and 103-2 according to the first embodiment, and are enlarged in diameter to contact with the pixel isolation section 109 in the A-A' cross-sectional direction.

As described above, by enlarging the diameter of the vertical gate electrodes 203-1 and 203-2 to the extent of being in contact with the pixel isolation section 109, it is possible to reduce the area where the transfer gate 203 and the semiconductor substrate 101 face each other via the gate insulating film 104, and thus, it is possible to reduce the parasitic capacitance between the transfer gate 203 and the semiconductor substrate 101 and enhance the transfer efficiency.

Furthermore, by enlarging the diameter of the vertical gate electrodes 203-1 and 203-2 to the extent of being in contact with the pixel isolation section 109, it is possible to suppress the charge from going around between the vertical gate electrode 203-1 or 203-2 and the pixel isolation section 109, and thus, it is possible to increase the transfer efficiency by restricting the transfer path of the charge.

Note that, in the above description, it is expressed that the vertical gate electrodes 203-1 and 203-2 are enlarged in diameter, but this may also include a case where individual pixel regions partitioned by the pixel isolation section 109 are reduced. In that case, the degree of freedom in layout design at the time of die shrinking of the pixel 200 can be increased.

Other configurations, operations, manufacturing processes, and effects may be similar to those of the above-described embodiment, and thus detailed description thereof is omitted here.

### 4. Third Embodiment

Next, an imaging apparatus and an electronic device according to the third embodiment will be described in detail with reference to the drawings. Note that, in the present embodiment, a pixel 300 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

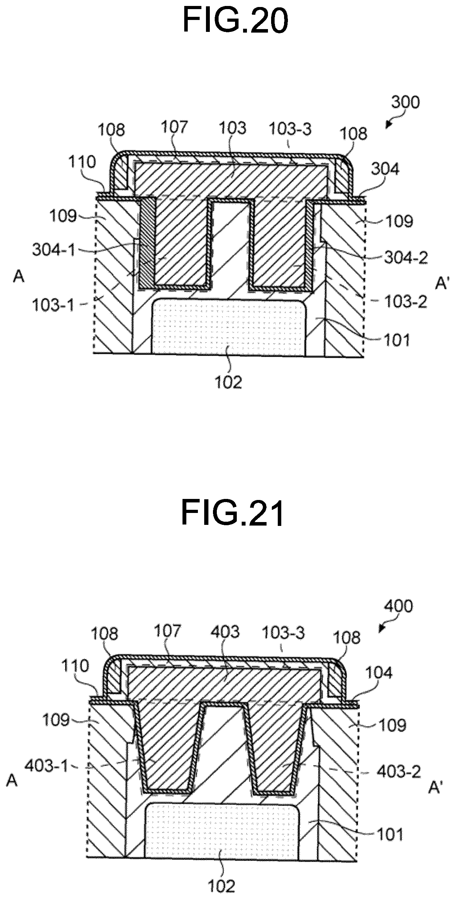

FIG. 20 is a vertical cross-sectional view depicting a schematic configuration example of a pixel according to the present embodiment. Note that the A-A' cross section in FIG. 20 may correspond to the A-A' in FIG. 5.

As depicted in FIG. 20, the pixel 300 according to the present embodiment has a structure in which the gate insulating film 104 are replaced with a gate insulating film 304 in the same configuration as the pixel 100 described with reference to FIGS. 5 to 8 in the first embodiment.

In the A-A' cross-sectional direction, the film thickness of the portion between the vertical gate electrode 103-1/103-2 and the pixel isolation section 109 in the gate insulating film 304 is thicker than the film thickness of the other portion. For example, a film thickness of the gate insulating film 304 provided on a side surface of the vertical gate electrode 103-1/103-2 and between the vertical gate electrode 103-1/103-2 and the pixel isolation section 109 is larger than a film thickness of the gate insulating film 304 provided on a bottom surface of the vertical gate electrode 103-1/103-2.

As described above, by thickening the gate insulating film 304 between the vertical gate electrodes 103-1/103-2 and the pixel isolation section 109, the parasitic capacitance between the transfer gate 203 and the semiconductor substrate 101 can be reduced, so that the transfer efficiency of the charge accumulated in the photoelectric conversion unit 102 can be increased.

Note that, in FIG. 20, like a gate insulating film 304-1 between the vertical gate electrode 103-1 and the pixel isolation section 109, the gate insulating film 304 between the vertical gate electrode 103-1 and/or 103-2 and the pixel isolation section 109 may be thickened to the extent of being in contact with the pixel isolation section 109. However, the present disclosure is not limited thereto, and like a gate insulating film 304-2 between the vertical gate electrode 103-2 and the pixel isolation section 109, the gate insulating film 304 between the vertical gate electrode 103-1 and/or 103-2 and the pixel isolation section 109 may be thickened to the extent of being not in contact with the pixel isolation section 109.

Other configurations, operations, manufacturing processes, and effects may be similar to those of the above-described embodiment, and thus detailed description thereof is omitted here.

### 5. Fourth Embodiment

Next, an imaging apparatus and an electronic device according to the fourth embodiment will be described in detail with reference to the drawings. Note that, in the present embodiment, a pixel 400 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

FIG. 21 is a vertical cross-sectional view depicting a schematic configuration example of a pixel according to the present embodiment. Note that the A-A' cross section in FIG. 21 may correspond to the A-A' in FIG. 5.

As depicted in FIG. 21, the pixel 400 according to the present embodiment has a structure in which the transfer gate 103 is replaced with a transfer gate 403 in the same configuration as the pixel 100 described with reference to FIGS. 5 to 8 in the first embodiment.

The transfer gate 403 includes a transfer gate electrode 103-3 similar to that of the first embodiment and a plurality of vertical gate electrodes 203-1 and 203-2.

Each of a vertical gate electrodes 403-1 and 403-2 has a tapered shape whose diameter decreases toward the bottom surface in a vertical cross section parallel to the array direction of the vertical gate electrodes 403-1 and 403-2. Note that the vertical cross section parallel to the array direction of the vertical gate electrodes 403-1 and 403-2 is, in other words, a plane perpendicular to the straight line connecting the floating diffusion region 105 and the ground contact 106, and a plane perpendicular to the channel length direction of the channel formed between the transfer gate 103 and the floating diffusion region 105.

As described above, by forming the vertical gate electrodes 403-1 and 403-2 in a tapered shape, it is possible to form a potential profile with low modulation on the bottom portion side and high modulation on the upper portion side, and thus, it is possible to increase the transfer efficiency of the charge accumulated in the photoelectric conversion unit 102.

Other configurations, operations, manufacturing processes, and effects may be similar to those of the above-described embodiment, and thus detailed description thereof is omitted here.

### 6. Fifth Embodiment

Next, an imaging apparatus and an electronic device according to the fifth embodiment will be described in detail with reference to the drawings. Note that, in the present embodiment, a pixel 500 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

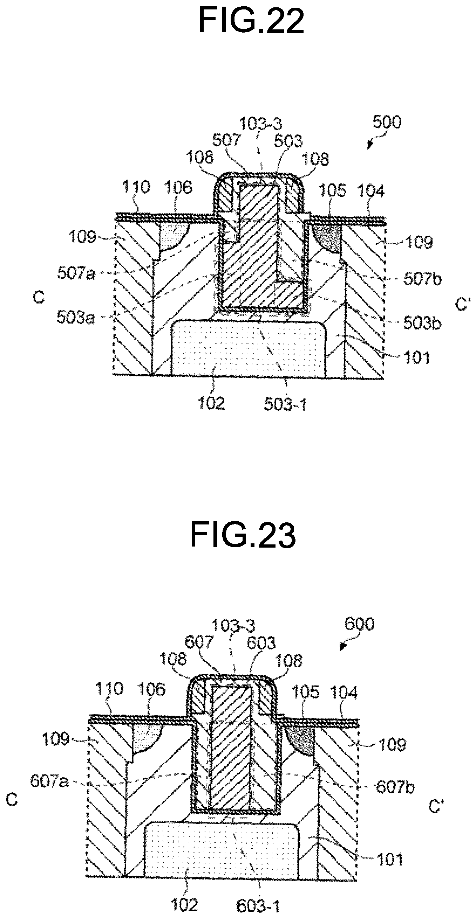

FIG. 22 is a vertical cross-sectional view depicting a schematic configuration example of a pixel according to the present embodiment. Note that the C-C' cross section in FIG. 22 may correspond to the C-C' in FIG. 5.

As depicted in FIG. 22, the pixel 500 according to the present embodiment has a structure in which the transfer gate 103 and the insulating film 107 are replaced with a transfer gate 503 and an insulating film 507 in the same configuration as the pixel 100 described with reference to FIGS. 5 to 8 in the first embodiment.

The transfer gate 503 includes a transfer gate electrode 103-3 similar to that of the first embodiment and a plurality of vertical gate electrodes 503-1 and 503-2 (however, FIG. 22 depicts only the vertical gate electrode 503-1).

In the vertical gate electrodes 503-1 and 503-2, the depths in the substrate thickness direction (depth direction) of the enlarged diameter portions 503a and 503b are different between the floating diffusion region 105 side and the ground contact 106 side in the same structure as the vertical gate electrodes 103-1 and 103-2 according to the first embodiment. In this example, the position in the depth direction of the upper surface of the enlarged diameter portion 503b on the floating diffusion region 105 side is set to be deeper than the position of the enlarged diameter portion 503a on the ground contact 106 side. However, the present invention is not limited thereto, and the position in the depth direction of the upper surface in the enlarged diameter portion 503a on the ground contact 106 side may be set to be deeper than the position in the enlarged diameter portion 503b on the floating diffusion region 105 side.

In addition, the insulating film 507 is configured to fill the inside of the trench A1 (See, for example, FIG. 15) according to the difference in the depth direction between the enlarged diameter portions 503a and 503b in the same structure as the insulating film 107 according to the first embodiment.

In this manner, by adopting a configuration in which the depths of the enlarged diameter portions 503a and 503b in the substrate thickness direction (depth direction) are different between the floating diffusion region 105 side and the ground contact 106 side, it is possible to expand the process margin at the time of manufacturing. For example, in the process described with reference to FIG. 15 in the first embodiment, between the floating diffusion region 105 side and the ground contact 106 side with the hard mask M2 interposed therebetween, the conductor layer 103A tends to be engraved deeper on the side of the floating diffusion region 105 having a wider distance from the side surface of the trench A1 (width in the channel direction), but even in such a case, it is possible to suppress the problem that the yield decreases due to the difference in the depth after digging.

Other configurations, operations, manufacturing processes, and effects may be similar to those of the above-described embodiment, and thus detailed description thereof is omitted here.

### 7. Sixth Embodiment

Next, an imaging apparatus and an electronic device according to the sixth embodiment will be described in detail with reference to the drawings. Note that, in the present embodiment, a pixel 600 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

FIG. 23 is a vertical cross-sectional view depicting a schematic configuration example of a pixel according to the present embodiment. Note that the C-C' cross section in FIG. 23 may correspond to the C-C' in FIG. 5.

As depicted in FIG. 23, the pixel 600 according to the present embodiment has a structure in which the transfer gate 103 and the insulating film 107 are replaced with a transfer gate 603 and an insulating film 607 in the same configuration as the pixel 100 described with reference to FIGS. 5 to 8 in the first embodiment.

The transfer gate 603 includes a transfer gate electrode 103-3 similar to that of the first embodiment and a plurality of vertical gate electrodes 603-1 and 603-2 (however, FIG. 23 depicts only the vertical gate electrode 603-1).

The vertical gate electrodes 603-1 and 603-2 have the same structure as the vertical gate electrodes 103-1 and 103-2 according to the first embodiment, and have a structure in which the enlarged diameter portions 103a and 103b are omitted.

The insulating film 607 is configured to fill the inside of the trench A1 (see, for example, FIG. 15) instead of the omitted enlarged diameter portions 103a and 103b.

As described above, by arranging the insulating film 607 on the side surface on the bottom portion side of the vertical gate electrodes 603-1/603-2 instead of the enlarged diameter portions 103a and 103b, the parasitic capacitance between the transfer gate 603 and the semiconductor substrate 101 can be reduced, so that the transfer efficiency of the charge accumulated in the photoelectric conversion unit 102 can be increased.

In addition, since the structure of the vertical gate electrodes 603-1 and 603-2 in the trench A1 can be simplified, the process margin at the time of the manufacturing process can be expanded.

Other configurations, operations, manufacturing processes, and effects may be similar to those of the above-described embodiment, and thus detailed description thereof is omitted here.

### 8. Seventh Embodiment

Next, an imaging apparatus and an electronic device according to the seventh embodiment will be described in detail with reference to the drawings. Note that, in the present embodiment, pixels 700-1 and 700-2 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

In the above-described embodiment, the case where one pixel 100, 200, 300, 400, 500, or 600 includes one floating diffusion region 105 has been exemplified, but the pixel 2 in the present disclosure may have a structure in which one floating diffusion region is shared by a plurality of pixels 2. Therefore, in the seventh embodiment, a case where two pixels 2 share one floating diffusion region will be exemplified.

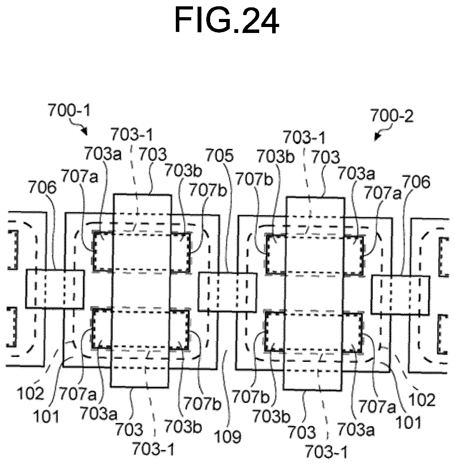

FIG. 24 is a plan view depicting a schematic configuration example of pixels according to the present embodiment. As depicted in FIG. 24, in the present embodiment, two pixels 700-1 and 700-2 adjacent in the row direction (lateral direction in the drawing) share one floating diffusion region 705. Furthermore, each of the pixels 700-1 and 700-2 may share the ground contact 706 with a pixel adjacent on the opposite side in the row direction. In the following description, when the pixels 700-1 and 700-2 are not distinguished from each other, their reference numerals are '700'.

Each pixel 700 has a configuration in which a photoelectric conversion unit 102, a transfer gate 703, and an insulating film 707 are provided in a pixel region of the semiconductor substrate 101 partitioned by the pixel isolation section 109. Each pixel 700 may include a gate insulating film 104 (not illustrated), a sidewall 108, and passivation 110.

The transfer gate 703 includes a transfer gate electrode 703-3 that traverses the pixel region in the column direction (vertical direction in the drawing), and a plurality of (two in this example) vertical gate electrodes 703-1 and 703-2 arrayed in the column direction along the transfer gate electrode 703-3, and has a π-shaped shape as a whole. On the bottom side of each of the vertical gate electrodes 703-1 and 703-2, enlarged diameter portions 703a and 703b are provided.

The insulating film 707 includes an embedded sidewall 707a provided to be interposed between the vertical gate electrodes 703-1 and 7-3-2 and the ground contact 706, and an embedded sidewall 707b provided to be interposed between the vertical gate electrodes 703-1 and 7-3-2 and the floating diffusion region 705, and is configured to cover, for example, the transfer gate 703.

In such a configuration, the floating diffusion region 705 shared by the two pixels 700-1 and 700-2 is configured to extend across the pixel isolation section 109 that partitions between the two pixels 700-1 and 700-2. For example, the floating diffusion region 705 includes diffusion regions formed in the vicinity of opposing sides of the pixel regions of the two pixels 700-1 and 700-2, and a conductor film configured to connect the diffusion regions on the semiconductor substrate 101.

Similarly, the ground contact 706 shared by the two pixels 700 includes, for example, diffusion regions formed in the vicinity of opposing sides of the pixel regions of the two pixels 700, and a conductor film configured to connect the diffusion regions on the semiconductor substrate 101.

As described above, even in a case where one floating diffusion region 705 is shared by two pixels 700, by enlarging the diameter of the photoelectric conversion unit 102 side of each of the vertical gate electrodes 703-1 and 703-2 so as to protrude from the transfer gate electrode 703-3, it is possible to increase the area of the surface of the transfer gate 703 facing the photoelectric conversion unit 102 while securing the distance from the transfer gate electrode 703-3 to the floating diffusion region 705 and/or the ground contact 706, and thus it is possible to suppress deterioration in transfer efficiency while suppressing deterioration in image quality due to formation of the strong electric field.

Other configurations, operations, manufacturing processes, and effects may be similar to those of the above-described embodiment, and thus detailed description thereof is omitted here.

### 9. Eighth Embodiment

Next, an imaging apparatus and an electronic device according to the eighth embodiment will be described in detail with reference to the drawings. Note that, in the present embodiment, pixels 800-1 to 800-4 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

In the seventh embodiment described above, the case where two pixels 700 share one floating diffusion region 705 is exemplified, whereas in the present embodiment, a case where four pixels 800-1 to 800-4 share one floating diffusion region is exemplified.

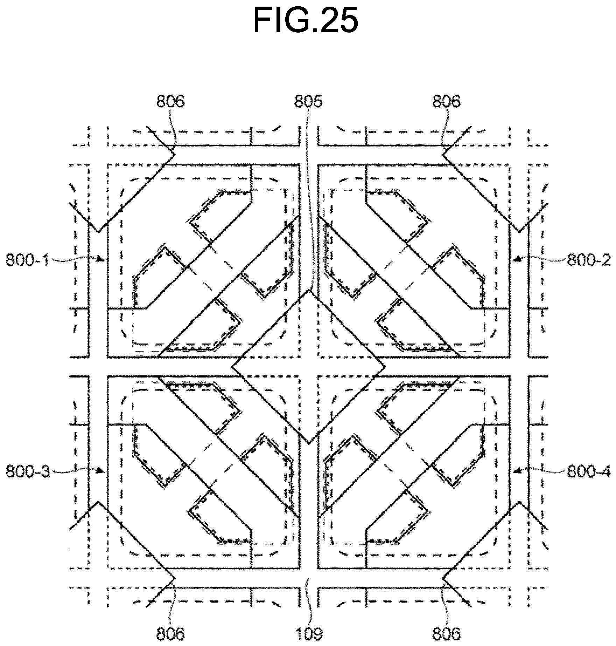

FIG. 25 is a plan view depicting a schematic configuration example of pixels according to the present embodiment. As depicted in FIG. 25, in the present embodiment, four pixels 800-1 to 800-4 arrayed in 2 × 2 share one floating diffusion region 805. Furthermore, each of the pixels 800-1 to 800-4 may share the ground contact 806 with a pixel adjacent on the opposite side in the oblique direction (also referred to as the diagonal direction). In the following description, when the pixels 800-1 to 800-4 are not distinguished from each other, their reference numerals are '800'.

Each pixel 800 may have a structure similar to any of the pixels 100, 200, 300, 400, 500, and 600 exemplified in the first to sixth embodiments described above, for example. At that time, the orientations of the pixels 800-1 to 800-4 may be changed so that the floating diffusion regions 105 gather at the center of the 2 × 2 array.

In such a configuration, the floating diffusion region 805 shared by the four pixels 800-1 to 800-4 includes the floating diffusion regions 105 aggregated at the center and a conductor film configured to connect them on the semiconductor substrate 101.

Similarly, the ground contact 806 shared by the four pixels 800 includes, for example, the ground contacts 106 aggregated at the center of the 2 × 2 array and a conductor film configured to connect them on the semiconductor substrate 101.

As described above, even in a case where one floating diffusion region 805 is shared by four pixels 800, by enlarging the diameter of the photoelectric conversion unit 102 side of each of the vertical gate electrodes 103-1 and 103-2 so as to protrude from the transfer gate electrode 103-3, it is possible to increase the area of the surface of the transfer gate 103 facing the photoelectric conversion unit 102 while securing the distance from the transfer gate electrode 103-3 to the floating diffusion region 805 and/or the ground contact 806, and thus it is possible to suppress deterioration in transfer efficiency while suppressing deterioration in image quality due to formation of the strong electric field.

Other configurations, operations, manufacturing processes, and effects may be similar to those of the above-described embodiment, and thus detailed description thereof is omitted here.

### 10. Ninth Embodiment

Next, an imaging apparatus and an electronic device according to the ninth embodiment will be described in detail with reference to the drawings. Note that, in the present embodiment, pixels 900-1 and 900-2 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

In the above-described embodiment, a case has been exemplified where each pixel 100, 200, 300, 400, 500, 600, 700, or 800 is provided in a pixel region divided into a substantially square by the pixel isolation section 109. However, the shape of the pixel region is not limited to a substantially square, and can be variously modified such as a rectangle, a trapezoid, a rhombus, a regular hexagon, a circle, or an ellipse. Therefore, in the ninth embodiment, a case where each pixel region is divided into rectangles long in the column direction will be exemplified.

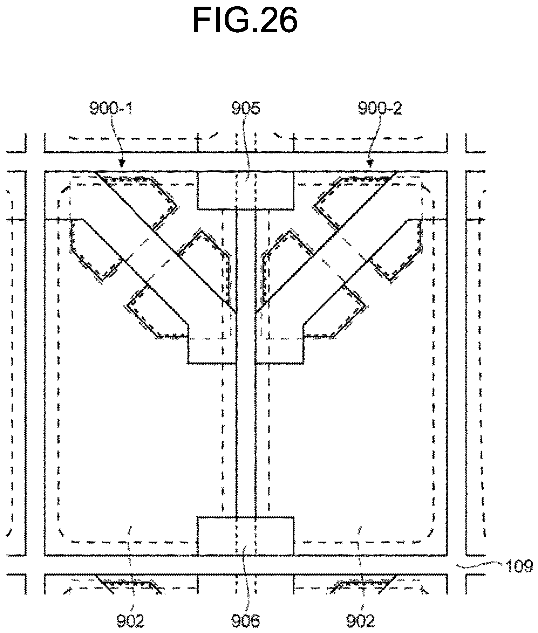

FIG. 26 is a plan view depicting a schematic configuration example of pixels according to the present embodiment. As depicted in FIG. 26, in the present embodiment, each pixel region partitioned by the pixel isolation section 109 has a rectangle elongated in the column direction.

In each pixel region, an element structure constituting the pixel 900-1 or 900-2 is provided to be biased to one side in the longitudinal direction of the rectangle. In the following description, when the pixels 900-1 and 900-2 are not distinguished from each other, their reference numerals are '900'.

The element structure of each pixel 900 may be any of the element structures of the pixels 100, 200, 300, 400, 500, and 600 according to the above-described embodiments. However, the photoelectric conversion unit 102 is replaced with a photoelectric conversion unit 902 extending over the entire pixel region.

Furthermore, in the present example, a case where one floating diffusion region 905 and one ground contact 906 are shared by two pixels 900-1 and 900-2 adjacent in the row direction will be exemplified. The floating diffusion region 905 may include, for example, a diffusion region formed at a corner where a side on which the element structure is arranged in proximity and a side facing the other pixel 900 sharing the floating diffusion region 905 intersect, and a conductor film connecting these diffusion regions across the pixel isolation section 109.

Similarly, the ground contact 906 may include, for example, a diffusion region formed at a corner where a side on the opposite to a side on which the element structure is arranged in proximity and a side facing the other pixel 900 sharing the floating diffusion region 905 intersect, and a conductor film connecting these diffusion regions across the pixel isolation section 109.

As described above, even in a case where each of the pixel regions has a shape other than a square, by enlarging the diameter of the photoelectric conversion unit 102 side of each of the vertical gate electrodes 103-1 and 103-2 so as to protrude from the transfer gate electrode 103-3, it is possible to increase the area of the surface of the transfer gate 103 facing the photoelectric conversion unit 102 while securing the distance from the transfer gate electrode 103-3 to the floating diffusion region 905 and/or the ground contact 906, and thus it is possible to suppress deterioration in transfer efficiency while suppressing deterioration in image quality due to formation of the strong electric field.

Other configurations, operations, manufacturing processes, and effects may be similar to those of the above-described embodiment, and thus detailed description thereof is omitted here.

### 11. Tenth Embodiment

Next, as the tenth embodiment, a modification of the pixel structure according to the above-described embodiment will be described. Note that, for the sake of clarity, the following description is based on the pixel structure according to the first embodiment, but the present embodiment is not limited thereto, and can be applied to other embodiments.

In the first embodiment described above (and other embodiments), by adopting a structure in which the bottom surface side of each of the vertical gate electrodes 103-1 and 103-2 is larger in diameter than the upper side, the area of the surface (bottom surface) of the transfer gate 103 facing the photoelectric conversion unit 102 is increased while securing the distance from the transfer gate electrode 103-3 to the floating diffusion region 105 and/or the ground contact 106. At that time, by providing the insulating film 107 (embedded sidewalls 107a and 107b) having a higher dielectric constant than that of the semiconductor substrate 101 on the side surface of the vertical gate electrode 103-1 other than the enlarged diameter portions 107a and 107b, it is possible to secure an electrical distance from the transfer gate 103 to the floating diffusion region 105 and/or the ground contact 106, thereby suppressing deterioration in image quality due to formation of a strong electric field between the transfer gate 103 and the floating diffusion region 105 and/or the ground contact 106 while suppressing deterioration in transfer efficiency.

On the other hand, in the present embodiment, a structure capable of further securing an electrical distance from the transfer gate 103 to the floating diffusion region 105 and/or the ground contact 106 will be exemplified. According to the structure according to the present embodiment, it is possible to further suppress deterioration in image quality due to formation of a strong electric field between the transfer gate 103 and the floating diffusion region 105 and/or the ground contact 106.

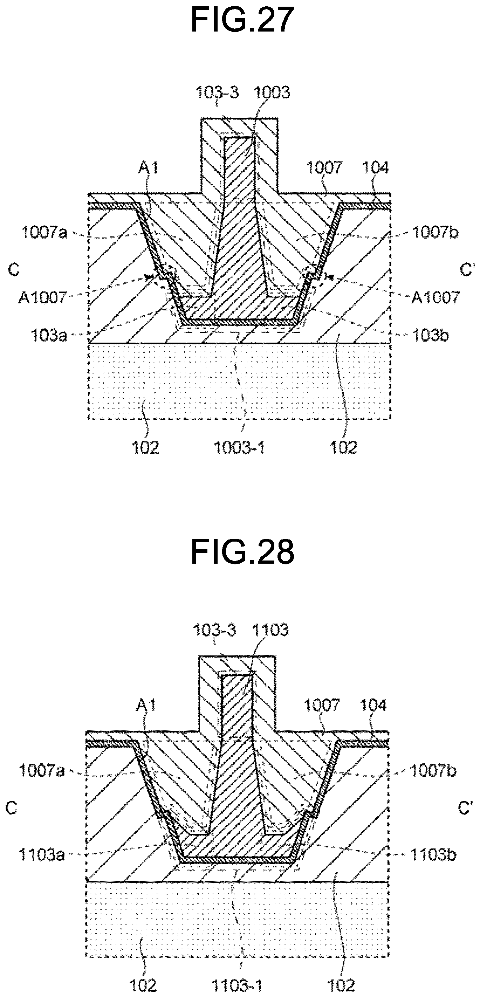

FIG. 27 is a partial cross-sectional view depicting a structure example of a pixel according to the present embodiment. Note that FIG. 27 illustrates an extracted feature of the structure around a transfer gate electrode 1003 from the cross-sectional structure of the surface corresponding to the C-C' cross section illustrated in FIG. 8 in the first embodiment.

As depicted in FIG. 27, in the present embodiment, the trench A1 (see FIG. 11) for providing the transfer gate has a structure in which the diameter is enlarged as approaching the surface (element formation surface) of the semiconductor substrate 101, and a vertical gate electrode 1003-1 including the enlarged diameter portions 103a and 103b and an insulating film 1007 including the embedded sidewalls 1007a and 1007b are provided in the trench A1. Therefore, the present embodiment has a structure in which the embedded sidewalls 1007a and 1007b are enlarged in diameter as approaching the surface (element formation surface) of the semiconductor substrate 101.

Having such structure, an electrical distance from the transfer gate 1003 to the floating diffusion region 105 and/or the ground contact 106 can be further secured, therefore, the intensity of the electric field formed between the transfer gate 1003 and the floating diffusion region 105 and/or the ground contact 106 can be further reduced.

In addition, in the present embodiment, by providing the step A1007 on the inner side surface of the trench A1, the embedded sidewalls 1007a and 1007b on the front surface (element formation surface) side of the semiconductor substrate 101 are configured to be further enlarged in diameter. As a result, an electrical distance from the transfer gate 1003 to the floating diffusion region 105 and/or the ground contact 106 can be further secured, therefore, the intensity of the electric field formed between the transfer gate 1003 and the floating diffusion region 105 and/or the ground contact 106 can be further reduced.

Other configurations, operations, and effects may be similar to those of the above-described embodiment, and thus detailed description thereof is omitted here.

### 12. Eleventh Embodiment

Next, as the eleventh embodiment, other modifications of the pixel structure according to the above-described embodiment will be described. Note that, for the sake of clarity, the following description is based on the pixel structure according to the tenth embodiment, but the present embodiment is not limited thereto, and can be applied to other embodiments.

The structures of the enlarged diameter portions 103a and 103b according to the above-described tenth embodiment (and other embodiments) are not limited to structures protruding in a direction parallel to the element formation surface of the semiconductor substrate 101 at the bottom portions of the vertical gate electrodes 1003-1/1003-2.

FIG. 28 is a partial cross-sectional view depicting a structure example of a pixel according to the present embodiment. Note that FIG. 28 illustrates, similarly to the tenth embodiment, an extracted feature of the structure around a transfer gate electrode 1103 from the cross-sectional structure of the surface corresponding to the C-C' cross section illustrated in FIG. 8 in the first embodiment.

As depicted in FIG. 28, the present embodiment has a structure in which the enlarged diameter portions 1103a and 1103b are warped along the inner surface of the trench A1. That is, the present embodiment has a structure in which the upper surfaces of the enlarged diameter portions 1103a and 1103b are warped toward the outside, so that the diameters of the enlarged diameter portions 1103a and 1103b are enlarged toward the outside.

With such a structure, the area of the surface of the vertical gate electrode 1103-1 facing the semiconductor substrate 101 can be increased, so that the modulation efficiency by the vertical gate electrodes 1103-1 and 1103-2 can be improved.

In addition, since the enlarged diameter portions 1103a and 1103b extend to a shallower position of the semiconductor substrate 101(that is, a position close to the element formation surface), the photoelectric conversion unit 102 can be provided to a shallower position of the semiconductor substrate 101. As a result, the photoelectric conversion region can be enlarged, therefore the photosensitivity of the pixel 2 can be further enhanced.

Other configurations, operations, and effects may be similar to those of the above-described embodiment, and thus detailed description thereof is omitted here.

### 13. Application Example to Mobile Body

The technology according to the present disclosure (present technology) can be applied to various products. For example, the technology according to the present disclosure may be realized as devices mounted on any types of mobile bodies such as automobiles, electric vehicles, hybrid electric vehicles, motorcycles, bicycles, personal mobilities, airplanes, drones, ships, and robots.

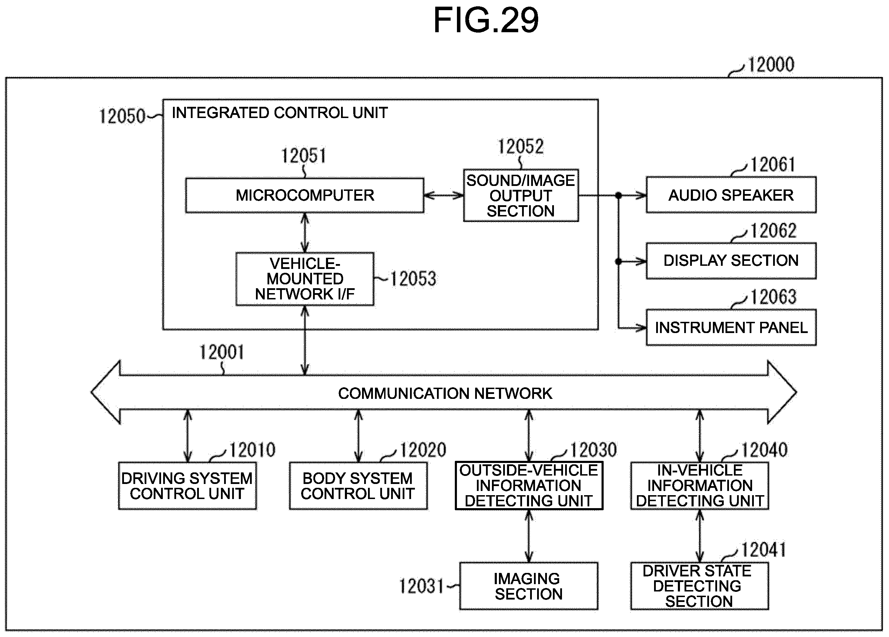

FIG. 29 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 29, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 29, an audio speaker 12061, a display section 12062, and an instrument panel 12063 are illustrated as the output device. The display section 12062 may, for example, include at least one of an on-board display and a head-up display.

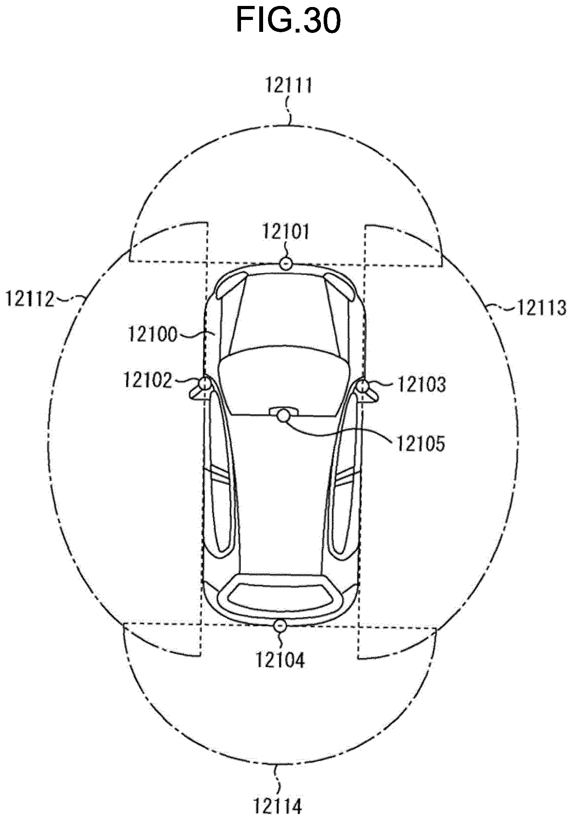

FIG. 30 is a diagram depicting an example of the installation position of the imaging section 12031.

In FIG. 30, a vehicle 12100 includes imaging sections 12101, 12102, 12103, 12104, and 12105 as the imaging section 12031.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The image of the front of the vehicle obtained by the imaging sections 12101 and 12105 is used mainly to detect a preceding vehicle, a pedestrian, an obstacle, a signal, a traffic sign, a lane, or the like.

Incidentally, FIG. 30 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the above, an example of the vehicle control system to which the technology related to the present disclosure can be applied is described. The technology according to the present disclosure can be applied to the imaging section 12031 within the above-described configuration. By applying the technology according to the present disclosure to the imaging section 12031, it is possible to acquire an image with good image quality, thereby achieving various effects such as improving the accuracy of various detection processes.

### 14. Application Example to Endoscopic Surgery System

The technology according to the present disclosure (present technology) can be applied to various products. For example, the technology according to the present disclosure may be applied to an endoscopic surgery system.

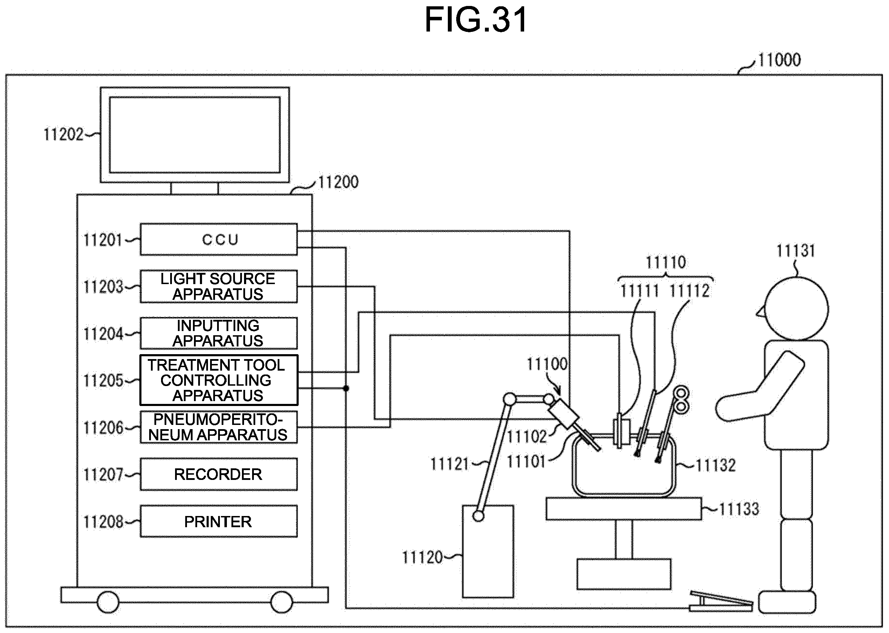

FIG. 31 is a view depicting an example of a schematic configuration of an endoscopic surgery system to which the technology according to an embodiment of the present disclosure (present technology) can be applied.

In FIG. 31, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

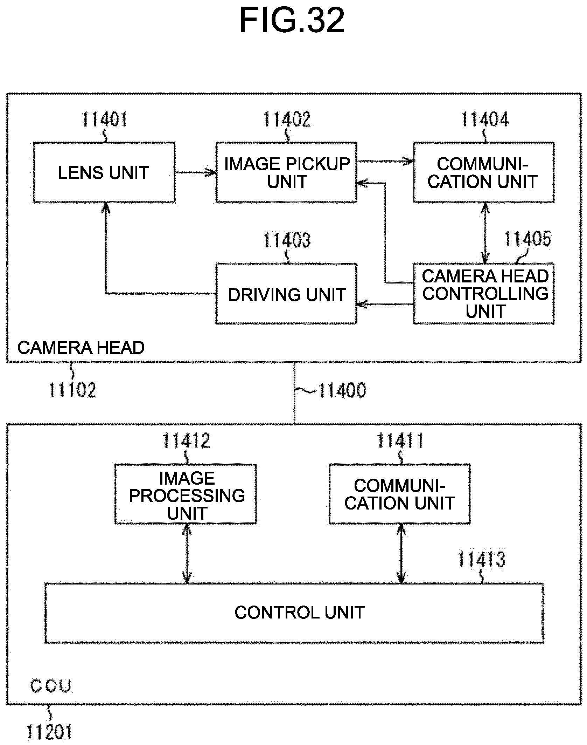

FIG. 32 is a block diagram depicting an example of a functional configuration of the camera head 11102 and the CCU 11201 depicted in FIG. 31.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The image pickup unit 11402 includes an image pickup element. The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

In the above, an example of the endoscopic surgery system to which the technology related to the present disclosure can be applied is described. The technology according to the present disclosure can be applied to, for example, the endoscope 11100, (the image pickup unit 11402 of) the camera head 11102, (the image processing unit 11412) of CCU 11201 or the like within the above-described configuration. By applying the technology according to the present disclosure to these configurations, a clearer image of the operation site can be obtained, so that the operator can reliably confirm the operation site.

Note that, here, the endoscopic surgery system has been described as an example, but the technology according to the present disclosure may be applied to, for example, a microscopic surgery system or the like.

Note that the present technology can also have the following configurations.
(1) An imaging apparatus including:
   a plurality of pixels arrayed in a two-dimensional lattice pattern, in which
   each of the pixels includes:
      a photoelectric conversion unit provided on a first surface side of a semiconductor substrate to perform photoelectric conversion of incident light;
      a vertical gate electrode provided on the semiconductor substrate so as to be close to the photoelectric conversion unit from a second surface side opposite to the first surface;
      a gate insulating film provided between the vertical gate electrode and the semiconductor substrate;
      a transfer gate electrode connected to the vertical gate electrode on the second surface of the semiconductor substrate; and
      a first diffusion region provided on a second surface side of the semiconductor substrate, and
      the vertical gate electrode has a structure in which a bottom portion on the photoelectric conversion unit side is enlarged in diameter more than an upper portion on the transfer gate electrode side, wherein the entire bottom portion with the enlarged diameter is provided at positions deeper than the depth position of the first diffusion region in a substrate thickness direction.
(2) The imaging apparatus according to (1), in which
   each of the pixels further includes an insulating film provided on a side surface of the upper portion of the vertical gate electrode and at least between the vertical gate electrode and the first diffusion region.
(3) The imaging apparatus according to (1) or (2), further including
   a pixel isolation section that partitions the second surface of the semiconductor substrate into a plurality of pixel regions, in which
   each of the pixels is provided on a one-to-one basis in each of the pixel regions.
(4) The imaging apparatus according to (3), in which
   each of the pixels further includes a second diffusion region provided on the second surface side of the semiconductor substrate,
   the first diffusion region is arranged at one of a plurality of corners of the pixel regions, and
   the second diffusion region is arranged at a corner located diagonally to a corner where the first diffusion region is arranged among the plurality of corners of the pixel regions.
(5) The imaging apparatus according to (4), in which
   the vertical gate electrode includes a plurality of vertical gate electrodes including a first vertical gate electrode and a second vertical gate electrode.
(6) The imaging apparatus according to (5), in which
   the first vertical gate electrode and the second vertical gate electrode are arranged in line symmetry with a line connecting the first diffusion region and the second diffusion region as a center line.
(7) The imaging apparatus according to any one of (4) to (6), in which
   at least a part of a side surface of the vertical gate electrode is in contact with the pixel isolation section with the gate insulating film interposed therebetween.
(8) The imaging apparatus according to any one of (4) to (7), in which
   a film thickness of the gate insulating film provided on a side surface of the vertical gate electrode and between the vertical gate electrode and the pixel isolation section is larger than a film thickness of the gate insulating film provided on a bottom surface of the vertical gate electrode.
(9) The imaging apparatus according to any one of (4) to (8), in which
   a cross-sectional shape of the vertical gate electrode in a plane perpendicular to a straight line connecting the first diffusion region and the second diffusion region is a tapered shape in which a diameter decreases toward a bottom surface.
(10) The imaging apparatus according to any one of (4) to (9), in which
   the bottom portion of the vertical gate electrode includes a first enlarged diameter portion protruding toward a side of the first diffusion region and a second enlarged diameter portion protruding toward a side of the second diffusion region, and
   a distance of an upper surface of the first enlarged diameter portion from the second surface is different from a distance of an upper surface of the second enlarged diameter portion from the second surface.
(11) The imaging apparatus according to any one of (3) to (10), in which
   a shape of the pixel region on the first surface is any of a square, a rectangle, a trapezoid, a rhombus, and a regular hexagon.
(12) The imaging apparatus according to any one of (1) to (11), in which
   the first diffusion region is shared by two or more of the pixels.
(13) The imaging apparatus according to any one of (1) to (12), further including
   a readout circuit connected to the transfer gate electrode, in which
   the readout circuit is provided on a second semiconductor substrate joined to the semiconductor substrate.
(14) The imaging apparatus according to (2), in which
   a diameter of the insulating film is enlarged on the second surface side more than on the first surface side of the semiconductor substrate.
(15) The imaging apparatus according to any one of (1) to (14), in which
   the enlarged diameter structure at the bottom portion of the vertical gate electrode is enlarged in diameter toward an outer side.
(16) An electronic device including the imaging apparatus according to any one of (1) to (15).

### Reference Signs List

1 IMAGING APPARATUS
2, 100, 200, 300, 400, 500, 600, 700-1 to 700-2, 800-1 to 800-4, 900-1 to 900-2 PIXEL
3 PIXEL ARRAY UNIT
4 VERTICAL DRIVE CIRCUIT
5 COLUMN SIGNAL PROCESSING CIRCUIT
6 HORIZONTAL DRIVE CIRCUIT
7 OUTPUT CIRCUIT
8 CONTROL CIRCUIT
10 FIRST SUBSTRATE
11, 21, 31, 101, ST SEMICONDUCTOR SUBSTRATE
20 SECOND SUBSTRATE
22 READOUT CIRCUIT
23 PIXEL DRIVE LINE
24 VERTICAL SIGNAL LINE
30 THIRD SUBSTRATE
32 LOGIC CIRCUIT
102, 902 PHOTOELECTRIC CONVERSION UNIT
103, 203, 403, 503, 603, 703, 1003, 1103 TRANSFER GATE
103a, 103b, 203a, 203b, 503a, 503b, 703a, 703b, 1103a, 1103b ENLARGED DIAMETER PORTION
103-1, 103-2, 203-1, 203-2, 403-1, 403-2, 503-1, 503-2, 603-1, 603-2, 703-1, 703-2, 1003-1, 1003-2, 1103-1, 1103-2 VERTICAL GATE ELECTRODE
103-3 TRANSFER GATE ELECTRODE
104, 304, 304-1, 304-2 GATE INSULATING FILM
105, 705, 805, 905, FD1 to FD4 FLOATING DIFFUSION REGION
106, 706, 806, 906 GROUND CONTACT
107, 207, 507, 607, 707, 1007 INSULATING FILM
107a, 107b, 207a, 207b, 507a, 507b, 607a, 607b, 707a, 707b, 1007a, 1007b EMBEDDED SIDEWALL
108 SIDEWALL
109 PIXEL ISOLATION SECTION
110 PASSIVATION
2001 ELECTRONIC DEVICE
2002 OPTICAL SYSTEM
2003 IMAGING APPARATUS
2004 DSP
2005 DISPLAY APPARATUS
2006 OPERATION SYSTEM
2007 BUS
2008 MEMORY
2009 RECORDING APPARATUS
2010 POWER SUPPLY SYSTEM
A1007 STEP
AMP AMPLIFICATION TRANSISTOR
HL HORIZONTAL SIGNAL LINE
I/O INPUT/OUTPUT CIRCUIT
PD1 to PD4 PHOTODIODE
RST RESET TRANSISTOR
SEL SELECTION TRANSISTOR
TR1 to TR4 TRANSFER TRANSISTOR

## Claims

1. An imaging apparatus (1) including
a plurality of pixels (2, 100, 200, 300, 400, 500, 600, 700-1 to 700-2, 800-1 to 800-4, 900-1 to 900-2) arrayed in a two-dimensional lattice pattern, wherein
each of the pixels includes:
a photoelectric conversion unit (102, 902) provided on a first surface side of a semiconductor substrate (101, ST) to perform photoelectric conversion of incident light;
a vertical gate electrode (103-1, 103-2, 203-1, 203-2, 403-1, 403-2, 503-1, 503-2, 603-1, 603-2, 703-1, 703-2, 1003-1, 1003-2, 1103-1, 1103-2) provided on the semiconductor substrate (101, ST) so as to be close to the photoelectric conversion unit (102, 902) from a second surface side opposite to the first surface;
a gate insulating film (104, 304, 304-1, 304-2) provided between the vertical gate electrode (103-1, 103-2) and the semiconductor substrate (101, ST);
a transfer gate electrode (103-3) connected to the vertical gate electrode (103-1, 103-2) on the second surface of the semiconductor substrate (101, ST); and
a first diffusion region (105, 705, 805, 905, FD1 to FD4) provided on a second surface side of the semiconductor substrate (101, ST), and
the vertical gate electrode (103-1, 103-2) has a structure in which a bottom portion (103a, 103b, 203a, 203b) on the photoelectric conversion unit (102, 902) side is enlarged in diameter more than an upper portion on the transfer gate electrode (103-3) side, **characterised in that**:
the entire bottom portion (103a, 103b, 203a, 203b) with the enlarged diameter is provided at positions deeper than the depth position of the first diffusion region (105, 705, 805, 905, FD1 to FD4) in a substrate thickness direction.

2. The imaging apparatus (1) according to claim 1, wherein
each of the pixels further includes an insulating film (107, 207, 507, 607, 707, 1007) provided on a side surface of the upper portion of the vertical gate electrode (103-1, 103-2) and at least between the vertical gate electrode (103-1, 103-2) and the first diffusion region (105, 705).

3. The imaging apparatus (1) according to claim 1 or 2, further including
a pixel isolation section (109) that partitions the second surface of the semiconductor substrate (101, ST) into a plurality of pixel regions, wherein
each of the pixels is provided on a one-to-one basis in each of the pixel regions.

4. The imaging apparatus (1) according to claim 3, wherein
each of the pixels further includes a second diffusion region provided on the second surface side of the semiconductor substrate(106, 706, 806, 906),
the first diffusion region (105, 705) is arranged at one of a plurality of corners of the pixel regions, and
the second diffusion region (106, 706) is arranged at a corner located diagonally to a corner where the first diffusion region (105, 705) is arranged among the plurality of corners of the pixel regions.

5. The imaging apparatus (1) according to claim 4, wherein
the vertical gate electrode includes a plurality of vertical gate electrodes including a first vertical gate electrode (103-1, 203-1) and a second vertical gate electrode (103-2, 203-2).

6. The imaging apparatus (1) according to claim 5, wherein
the first vertical gate electrode (103-1, 203-1) and the second vertical gate electrode (103-2, 203-2) are arranged in line symmetry with a line connecting the first diffusion region (105, 705) and the second diffusion region (106, 706) as a center line.

7. The imaging apparatus (1) according to any one of the claims 4 to 6, wherein
at least a part of a side surface of the vertical gate electrode (103-1, 103-2) is in contact with the pixel isolation section (109) with the gate insulating film (104, 304) interposed therebetween.

8. The imaging apparatus (1) according to any one of the claims 4 to 7, wherein
a film thickness of the gate insulating film (304-1, 304-2) provided on a side surface of the vertical gate electrode (103-1, 103-2) and between the vertical gate electrode (103-1, 103-2) and the pixel isolation section (109) is larger than a film thickness of the gate insulating film (104, 304) provided on a bottom surface of the vertical gate electrode (103-1, 103-2).

9. The imaging apparatus (1) according to any one of the claims 4 to 8, wherein
a cross-sectional shape of the vertical gate electrode (403-1, 403-2) in a plane perpendicular to a straight line connecting the first diffusion region (105, 705) and the second diffusion region (106, 706) is a tapered shape in which a diameter decreases toward a bottom surface.

10. The imaging apparatus (1) according to any one of the claims 4 to 9, wherein
the bottom portion of the vertical gate electrode (503-1, 503-2) includes a first enlarged diameter portion (503a) protruding toward a side of the first diffusion region (105, 705) and a second enlarged diameter portion (503b) protruding toward a side of the second diffusion region (106, 706), and
a distance of an upper surface of the first enlarged diameter portion (503a) from the second surface is different from a distance of an upper surface of the second enlarged diameter portion (503b) from the second surface.

11. The imaging apparatus (1) according to any one of the claims 3 to 10, wherein
a shape of the pixel region on the first surface is any of a square, a rectangle, a trapezoid, a rhombus, and a regular hexagon.

12. The imaging apparatus (1) according to any one of the claims 1 to 11, wherein
the first diffusion region (105, 705) is shared by two or more of the pixels, and/or further including
a readout circuit (22) connected to the transfer gate electrode (103-3), wherein
the readout circuit (22) is provided on a second semiconductor substrate (20) joined to the semiconductor substrate (101, ST).

13. The imaging apparatus (1) according to claim 2, wherein
a diameter of the insulating film (107, 207) is enlarged on the second surface side more than on the first surface side of the semiconductor substrate (101, ST).

14. The imaging apparatus (1) according to any one of the claims 1 to 13, wherein
the enlarged diameter structure at the bottom portion of the vertical gate electrode (103-1, 103-2) is enlarged in diameter toward an outer side.

15. An electronic device (2001) including the imaging apparatus (1) according to any one of claims 1 to 14.

## Patentansprüche

1. Bildgebungseinrichtung (1), die einschließt
eine Vielzahl von Pixel (2, 100, 200, 300, 400, 500, 600, 700-1 bis 700-2, 800-1 bis 800-4, 900-1 bis 900-2), die in einem zweidimensionalen Gittermuster angeordnet sind, wobei
jedes der Pixel einschließt:
eine fotoelektrische Umwandlungseinheit (102, 902), die auf einer ersten Oberflächenseite eines Halbleitersubstrats (101, ST) bereitgestellt ist, um eine fotoelektrische Umwandlung von einfallendem Licht durchzuführen;
eine vertikale Gate-Elektrode (103-1, 103-2, 203-1, 203-2, 403-1, 403-2, 503-1, 503-2, 603-1, 603-2, 703-1, 703-2, 1003-1, 1003-2, 1103-1, 1103-2), die auf dem Halbleitersubstrat (101, ST) bereitgestellt ist, um von einer zweiten Oberflächenseite gegenüber der ersten Oberfläche nahe an der photoelektrischen Umwandlungseinheit (102, 902) zu sein;
einen Gate-Isolierfilm (104, 304, 304-1, 304-2), der zwischen der vertikalen Gate-Elektrode (103-1, 103-2) und dem Halbleitersubstrat (101, ST) bereitgestellt ist;
eine Überführungs-Gate-Elektrode (103-3), die mit der vertikalen Gate-Elektrode (103-1, 103-2) auf der zweiten Oberfläche des Halbleitersubstrats (101, ST) verbunden ist; und
eine erste Diffusionsregion (105, 705, 805, 905, FD1 bis FD4), die auf einer zweiten Oberflächenseite des Halbleitersubstrats (101, ST) bereitgestellt ist, und
wobei die vertikale Gate-Elektrode (103-1, 103-2) eine Struktur aufweist, in der ein unterer Abschnitt (103a, 103b, 203a, 203b) auf der Seite der photoelektrischen Umwandlungseinheit (102, 902) in einem Durchmesser stärker als ein oberer Abschnitt auf der Seite der Überführungs-Gate-Elektrode (103-3) vergrößert ist, **dadurch gekennzeichnet, dass:**
der gesamte untere Abschnitt (103a, 103b, 203a, 203b) mit dem vergrößerten Durchmesser in einer Substratdickenrichtung an Positionen bereitgestellt ist, die tiefer als die Tiefenposition der ersten Diffusionsregion (105, 705, 805, 905, FD1 bis FD4) sind.

2. Bildgebungseinrichtung (1) nach Anspruch 1, wobei
jedes der Pixel ferner einen Isolierfilm (107, 207, 507, 607, 707, 1007) einschließt, der auf einer Seitenoberfläche des oberen Abschnitts der vertikalen Gate-Elektrode (103-1, 103-2) und mindestens zwischen der vertikalen Gate-Elektrode (103-1, 103-2) und der ersten Diffusionsregion (105, 705) bereitgestellt ist.

3. Bildgebungseinrichtung (1) nach Anspruch 1 oder 2, die ferner einschließt
einen Pixelisolationsbereich (109), der die zweite Oberfläche des Halbleitersubstrats (101, ST) in eine Vielzahl von Pixelregionen unterteilt, wobei
jedes der Pixel auf einer Eins-zu-eins-Basis in jeder der Pixelregionen bereitgestellt ist.

4. Bildgebungseinrichtung (1) nach Anspruch 3, wobei
jedes der Pixel ferner eine zweite Diffusionsregion einschließt, die auf der zweiten Oberflächenseite des Halbleitersubstrats (106, 706, 806, 906) bereitgestellt ist,
die erste Diffusionsregion (105, 705) an einer von einer Vielzahl von Ecken der Pixelregionen eingerichtet ist und
die zweite Diffusionsregion (106, 706) an einer Ecke eingerichtet ist, die sich diagonal zu einer Ecke befindet, an der die erste Diffusionsregion (105, 705) unter der Vielzahl von Ecken der Pixelregionen eingerichtet ist.

5. Bildgebungseinrichtung (1) nach Anspruch 4, wobei
die vertikale Gate-Elektrode eine Vielzahl von vertikalen Gate-Elektroden einschließt, die eine erste vertikale Gate-Elektrode (103-1, 203-1) und eine zweite vertikale Gate-Elektrode (103-2, 203-2) einschließen.

6. Bildgebungseinrichtung (1) nach Anspruch 5, wobei
die erste vertikale Gate-Elektrode (103-1, 203-1) und die zweite vertikale Gate-Elektrode (103-2, 203-2) in Spiegelsymmetrie mit einer Linie eingerichtet sind, die die erste Diffusionsregion (105, 705) und die zweite Diffusionsregion (106, 706) als eine Mittellinie verbindet.

7. Bildgebungseinrichtung (1) nach einem der Ansprüche 4 bis 6, wobei
mindestens ein Teil einer Seitenoberfläche der vertikalen Gate-Elektrode (103-1, 103-2) in Kontakt mit dem Pixelisolationsbereich (109) steht, wobei der Gate-Isolierfilm (104, 304) dazwischengestellt ist.

8. Bildgebungseinrichtung (1) nach einem der Ansprüche 4 bis 7, wobei
eine Filmdicke des Gate-Isolierfilms (304-1, 304-2), der auf einer Seitenoberfläche der vertikalen Gate-Elektrode (103-1, 103-2) und zwischen der vertikalen Gate-Elektrode (103-1, 103-2) und dem Pixelisolationsbereich (109) bereitgestellt ist, größer als eine Filmdicke des Gate-Isolierfilms (104, 304) ist, der auf einer unteren Oberfläche der vertikalen Gate-Elektrode (103-1, 103-2) bereitgestellt ist.

9. Bildgebungseinrichtung (1) nach einem der Ansprüche 4 bis 8, wobei
eine Querschnittform der vertikalen Gate-Elektrode (403-1, 403-2) in einer Ebene senkrecht zu einer Geraden, die die erste Diffusionsregion (105, 705) und die zweite Diffusionsregion (106, 706) verbindet, eine sich verjüngende Form ist, in der ein Durchmesser zu einer unteren Oberfläche hin abnimmt.

10. Bildgebungseinrichtung (1) nach einem der Ansprüche 4 bis 9, wobei
der untere Abschnitt der vertikalen Gate-Elektrode (503-1, 503-2) einen ersten Abschnitt (503a) mit vergrößertem Durchmesser, der zu einer Seite der ersten Diffusionsregion (105, 705) hin vorsteht, und einen zweiten Abschnitt (503b) mit vergrößertem Durchmesser, der zu einer Seite der zweiten Diffusionsregion (106, 706) hin vorsteht, einschließt und
ein Abstand einer oberen Oberfläche des ersten Abschnitts mit vergrößertem Durchmesser (503a) von der zweiten Oberfläche sich von einem Abstand einer oberen Oberfläche des zweiten Abschnitts mit vergrößertem Durchmesser (503b) von der zweiten Oberfläche unterscheidet.

11. Bildgebungseinrichtung (1) nach einem der Ansprüche 3 bis 10, wobei
eine Form der Pixelregion auf der ersten Oberfläche ein beliebiges von einem Quadrat, einem Rechteck, einem Trapez, einem Rhombus und einem regelmäßigen Sechseck ist.

12. Bildgebungseinrichtung (1) nach einem der Ansprüche 1 bis 11, wobei
die erste Diffusionsregion (105, 705) durch zwei oder mehr der Pixel gemeinsam genutzt wird und/oder ferner einschließt
eine Ausleseschaltung (22), die mit der Überführungs-Gate-Elektrode (103-3) verbunden ist, wobei
die Ausleseschaltung (22) auf einem zweiten Halbleitersubstrat (20) bereitgestellt ist, das an das Halbleitersubstrat (101, ST) angekoppelt ist.

13. Bildgebungseinrichtung (1) nach Anspruch 2, wobei
ein Durchmesser des Isolierfilms (107, 207) auf der zweiten Oberflächenseite stärker als auf der ersten Oberflächenseite des Halbleitersubstrats (101, ST) vergrößert ist.

14. Bildgebungseinrichtung (1) nach einem der Ansprüche 1 bis 13, wobei
die Struktur mit vergrößertem Durchmesser an dem unteren Abschnitt der vertikalen Gate-Elektrode (103-1, 103-2) in dem Durchmesser zu einer Außenseite hin vergrößert ist.

15. Elektronische Vorrichtung (2001), die die Bildgebungseinrichtung (1) nach einem der Ansprüche 1 bis 14 einschließt.

## Revendications

1. Appareil d'imagerie (1) comportant
une pluralité de pixels (2, 100, 200, 300, 400, 500, 600, 700-1 à 700-2, 800-1 à 800-4, 900-1 à 900-2) disposés selon un motif de réseau bidimensionnel, dans lequel
chacun des pixels comporte :
une unité de conversion photoélectrique (102, 902) prévue sur un côté première surface d'un substrat semi-conducteur (101, ST) pour effectuer une conversion photoélectrique de lumière incidente ;
une électrode de grille verticale (103-1, 103-2, 203-1, 203-2, 403-1, 403-2, 503-1, 503-2, 603-1, 603-2, 703-1, 703-2, 1003-1, 1003-2, 1103-1, 1103-2) prévue sur le substrat semi-conducteur (101, ST) de manière à être proche de l'unité de conversion photoélectrique (102, 902) à partir d'un côté seconde surface opposée à la première surface ;
un film isolant de grille (104, 304, 304-1, 304-2) prévu entre l'électrode de grille verticale (103-1, 103-2) et le substrat semi-conducteur (101, ST) ;
une électrode de grille de transfert (103-3) connectée à l'électrode de grille verticale (103-1, 103-2) sur la seconde surface du substrat semi-conducteur (101, ST) ; et
une première région de diffusion (105, 705, 805, 905, FD1 à FD4) prévue sur un côté seconde surface du substrat semi-conducteur (101, ST), et
l'électrode de grille verticale (103-1, 103-2) présente une structure dans laquelle une partie inférieure (103a, 103b, 203a, 203b) située sur le côté unité de conversion photoélectrique (102, 902) présente un diamètre élargi davantage qu'une partie supérieure située sur le côté électrode de grille de transfert (103-3), **caractérisé en ce que :**
l'ensemble de la partie inférieure (103a, 103b, 203a, 203b) présentant le diamètre élargi est prévue au niveau de positions plus profondes que la position de profondeur de la première région de diffusion (105, 705, 805, 905, FD1 à FD4) dans une direction d'épaisseur de substrat.

2. Appareil d'imagerie (1) selon la revendication 1, dans lequel
chacun des pixels comporte en outre un film isolant (107, 207, 507, 607, 707, 1007) prévu sur une surface latérale de la partie supérieure de l'électrode de grille verticale (103-1, 103-2) et au moins entre l'électrode de grille verticale (103-1, 103-2) et la première région de diffusion (105, 705).

3. Appareil d'imagerie (1) selon la revendication 1 ou 2, comportant en outre
une section d'isolation de pixels (109) qui divise la seconde surface du substrat semi-conducteur (101, ST) en une pluralité de régions de pixels, dans lequel
chacun des pixels est prévu, sur une base individuelle, dans chacune des régions de pixels.

4. Appareil d'imagerie (1) selon la revendication 3, dans lequel
chacun des pixels comporte en outre une seconde région de diffusion prévue sur le côté seconde surface du substrat semi-conducteur (106, 706, 806, 906),
la première région de diffusion (105, 705) est agencée au niveau de l'un parmi une pluralité de coins des régions de pixels, et
la seconde région de diffusion (106, 706) est agencée au niveau d'un coin situé en diagonale par rapport à un coin où la première région de diffusion (105, 705) est agencée parmi la pluralité de coins des régions de pixels.

5. Appareil d'imagerie (1) selon la revendication 4, dans lequel
l'électrode de grille verticale comporte une pluralité d'électrodes de grille verticales qui comportent une première électrode de grille verticale (103-1, 203-1) et une seconde électrode de grille verticale (103-2, 203-2).

6. Appareil d'imagerie (1) selon la revendication 5, dans lequel
la première électrode de grille verticale (103-1, 203-1) et la seconde électrode de grille verticale (103-2, 203-2) sont agencées en symétrie axiale avec une ligne reliant la première région de diffusion (105, 705) et la seconde région de diffusion (106, 706), qui sert de ligne centrale.

7. Appareil d'imagerie (1) selon l'une quelconque des revendications 4 à 6, dans lequel
au moins une partie d'une surface latérale de l'électrode de grille verticale (103-1, 103-2) est en contact avec la section d'isolation de pixels (109), le film isolant de grille (104, 304) étant interposé entre celles-ci.

8. Appareil d'imagerie (1) selon l'une quelconque des revendications 4 à 7, dans lequel
une épaisseur de film du film isolant de grille (304-1, 304-2), prévu sur une surface latérale de l'électrode de grille verticale (103-1, 103-2) et entre l'électrode de grille verticale (103-1, 103-2) et la section d'isolation de pixels (109), est supérieure à une épaisseur de film du film isolant de grille (104, 304) prévu sur une surface inférieure de l'électrode de grille verticale (103-1, 103-2).

9. Appareil d'imagerie (1) selon l'une quelconque des revendications 4 à 8, dans lequel
une forme de section transversale de l'électrode de grille verticale (403-1, 403-2), dans un plan perpendiculaire à une ligne droite reliant la première région de diffusion (105, 705) et la seconde région de diffusion (106, 706), est une forme conique dans laquelle un diamètre diminue vers une surface inférieure.

10. Appareil d'imagerie (1) selon l'une quelconque des revendications 4 à 9, dans lequel
la partie inférieure de l'électrode de grille verticale (503-1, 503-2) comporte une première partie de diamètre élargi (503a) faisant saillie vers un côté de la première région de diffusion (105, 705) et une seconde partie de diamètre élargi (503b) faisant saillie vers un côté de la seconde région de diffusion (106, 706), et
une distance entre une surface supérieure de la première partie de diamètre élargi (503a) et la seconde surface est différente d'une distance entre une surface supérieure de la seconde partie de diamètre élargi (503b) et la seconde surface.

11. Appareil d'imagerie (1) selon l'une quelconque des revendications 3 à 10, dans lequel
une forme de la région de pixels sur la première surface est l'un quelconque parmi un carré, un rectangle, un trapèze, un losange et un hexagone régulier.

12. Appareil d'imagerie (1) selon l'une quelconque des revendications 1 à 11, dans lequel
la première région de diffusion (105, 705) est partagée par deux ou plusieurs des pixels, et/ou comportant en outre
un circuit de lecture (22) connecté à l'électrode de grille de transfert (103-3), dans lequel
le circuit de lecture (22) est prévu sur un second substrat semi-conducteur (20) relié au substrat semi-conducteur (101, ST).

13. Appareil d'imagerie (1) selon la revendication 2, dans lequel
un diamètre du film isolant (107, 207) est élargi davantage sur le côté seconde surface que le côté première surface du substrat semi-conducteur (101, ST).

14. Appareil d'imagerie (1) selon l'une quelconque des revendications 1 à 13, dans lequel
la structure de diamètre élargi au niveau de la partie inférieure de l'électrode de grille verticale (103-1, 103-2) présente un diamètre élargi vers un côté externe.

15. Dispositif électronique (2001) comportant l'appareil d'imagerie (1) selon l'une quelconque des revendications 1 à 14.
